# EUROPEAN PATENT APPLICATION

(11) **EP 4 814 506 A1**
(43) Date of publication of application: **30.09.2026**
(21) Application number: 24894313.6
(22) Date of filing: 20.08.2024
(51) Int. Cl.: G01R 31/12, G01R 27/02, G01R 23/02, G01R 23/16, G01R 15/18, G01R 19/175, H02H 3/00, G01R 19/10, G01R 23/00

(54) **INSULATION MONITORING SYSTEM AND CONTROL METHOD THEREOF**

(30) Priority: 24.11.2023 KR 20230165818; 24.11.2023 KR 20230165819
(71) Applicant: LS Electric Co., Ltd., Anyang-si, Gyeonggi-do 14119 (KR)
(72) Inventor: YUN, Dongjin, Anyang-si Gyeonggi-do 14118 (KR)
(74) Representative: K&L Gates LLP
(86) International application number: PCT/KR2024/012355
(87) International publication number: WO 2025/110416

(57) **Abstract**

An insulation monitoring system according to an embodiment of the present invention comprises: an arc monitoring unit which detects a high-frequency current signal from a power line connecting a power source and a load, and monitors generation of an arc due to insulation damage of the power line on the basis of the detected high-frequency current signal; an insulation monitoring unit which calculates an insulation resistance between the power line and a ground, and monitors an insulation state of the power line on the basis of the calculated insulation resistance; a circuit breaker which breaks an electrical connection between the power line and the load according to whether a blocking signal is received; and a control unit which is connected to the arc monitoring unit and the insulation monitoring unit, receives at least one of an insulation monitoring result related to generation of the arc from the arc monitoring unit and an insulation monitoring result related to the insulation resistance from the insulation monitoring unit, and outputs the blocking signal to the circuit breaker on the basis of the received insulation monitoring result.

## Description

### Technical Field

The present disclosure relates to a system for monitoring an insulation state of a power line.

### Background Art

Conventionally, an insulation monitoring device (IMD) is placed between the ground and an ungrounded power line that is supplied with power, and can refer to a device that can monitor an insulation state of the power line by applying a square wave pulse signal (voltage: Vp) to a circuit formed between the power line and the ground by a pulse signal generation part, calculating an insulation resistance Re based on a signal (voltage: Vm) in which a voltage is distributed by a virtual resistance (insulation resistance Re) between the power line and the ground and an internal resistance Ri of the insulation monitoring device from the applied pulse signal Vp, and comparing a magnitude of the calculated insulation resistance with a reference value.

In order to calculate the insulation resistance, the pulse signal generation part must inject a pulse signal whose polarity is reversed into the circuit at a predetermined time period. However, since there is a virtual capacitance, that is, an insulating capacitor, between the power line and the ground, when the polarity of the pulse signal is reversed, charging and discharging of the insulating capacitor occurs due to a voltage difference of the reversed pulse signal, which causes a transient phenomenon in which the voltage increases and becomes unstable. The transient phenomenon is temporary, and when a predetermined time period has elapsed until charging and discharging of the insulation capacitor is completed, the voltage is stabilized again.

However, in the transient state, an insulation resistance of the power line to be measured and a component of the insulation capacitance are mixed, thereby having a large error. Therefore, it is difficult to calculate an accurate insulation resistance, and thus a conventional insulation monitoring device calculates the insulation resistance after the transient phenomenon has ended, that is, after the transient period has elapsed and the voltage has stabilized.

Accordingly, in the case of the conventional insulation monitoring device, there is a problem in that a relatively long time period is required until the insulation resistance is calculated after a voltage polarity of the pulse signal is reversed. Since it takes a long time to calculate the insulation resistance, the insulation state of the power line according to the insulation resistance cannot be detected during a time period until the insulation resistance is calculated, that is, during a voltage stabilization period, and thus, there is a problem in that a power apparatus is vulnerable to damage or an occurrence of a safety accident due to a ground-fault current caused by insulation breakdown or insulation damage (hereinafter collectively referred to as insulation breakdown).

Meanwhile, for the voltage stabilization, the conventional insulation monitoring device waits until an initial waiting time period has elapsed after the polarity of the pulse signal has been reversed, and performs sampling after the initial waiting time period has elapsed to distinguish whether the voltage has been stabilized. Therefore, there is a problem in that it is difficult to monitor an insulation of the power line during a time period until the voltage is stabilized after the polarity of the pulse signal is reversed.

Meanwhile, when insulation breakdown of the power line, or connection defect or aging of the power line occurs, an arc can occur in the power line. The arc refers to an electric flame or spark, which refers to a discharge phenomenon that occurs when a high voltage potential difference occurs between the positive and negative terminals, and has a characteristic of a high current density.

The arc is known to be a major cause of electrical fires, as it can cause fire if there is an ignition material therearound. Furthermore, in the case of the arc, when a current above a predetermined magnitude is detected through a current leakage circuit breaker or overcurrent circuit breaker, it is distinguished and detected as a current leakage or overcurrent.

However, in the case of an arc, it can occur even at a low current of about 3 to 5 A, and there is a problem in that it is difficult to detect with a leakage circuit breaker or overcurrent circuit breaker in the case of an arc that occurs at such a low current or an arc that occurs for less than a predetermined time period. Accordingly, research is actively being conducted to detect and interrupt an arc, including mandating the installation of an arc circuit breaker that can interrupt such an arc in various countries.

### Disclosure of Invention

### Technical Problem

The present disclosure is intended to solve the foregoing problems, and an aspect of the present disclosure is to provide an insulation monitoring system capable of monitoring an insulation state of a power line even during the voltage stabilization period, and a control method of the system.

Furthermore, another aspect of the present disclosure is to provide an insulation monitoring system capable of monitoring not only an insulation state of a power line but also an arc occurring due to insulation breakdown of the power line, and a control method of the system.

In addition, still another aspect of the present disclosure is to provide an insulation monitoring system capable of monitoring an insulation state of the power line through an insulation monitoring function that combines the insulation monitoring function and the arc monitoring function, and more quickly interrupting an electrical connection to the power line when insulation breakdown is detected, and a control method of the system.

Moreover, yet still another aspect of the present disclosure is to provide an insulation monitoring device that not only calculates an insulation resistance of a power line to monitor the insulation state of the power line, but also monitors whether an arc occurs in the power line, and a control method of the device.

Besides, still yet another aspect of the present disclosure is to provide an insulation monitoring device capable of minimizing a time period in which insulation monitoring is not performed by the insulation monitoring device by monitoring an insulation state of a power line through the arc monitoring during a time period in which the insulation monitoring device is unable to monitor the insulation state of the power line, and a control method of the device.

### Solution to Problem

In order to achieve the foregoing objectives, an insulation monitoring system according to an embodiment of the present disclosure can include an arc monitoring part that detects a high-frequency current signal from a power line connecting between a power source and a load and monitors an occurrence of an arc due to insulation damage of the power line based on the detected high-frequency current signal, an insulation monitoring part that calculates an insulation resistance between the power line and the ground and monitors an insulation state of the power line based on the calculated insulation resistance, a circuit breaker that interrupts an electrical connection between the power line and the load depending on whether an interruption signal is received, and a control part connected to the arc monitoring part and the insulation monitoring part to receive at least one of an insulation monitoring result related to the occurrence of the arc from the arc monitoring part and an insulation monitoring result related to the insulation resistance from the insulation monitoring part, and output the interruption signal to the circuit breaker based on the received insulation monitoring result.

In one embodiment, the insulation monitoring result received from the arc monitoring part can include a signal intensity change pattern of a high-frequency current signal detected from the power line, wherein the control part distinguishes the insulation state of the power line based on whether the signal intensity change pattern matches a pre-stored arc pattern.

In one embodiment, the signal intensity change pattern can be a pattern according to an intensity change of a high-frequency current signal detected at each of a second time point between a first time point at which an AC current flowing in the power line reaches a zero crossing point (ZCP), and a third time point corresponding to a 1/4 cycle of the AC current, and a fourth time point between the third time point and a time point at which it reaches the ZCP again, wherein the arc pattern is a pattern corresponding to a phased signal intensity change of a high-frequency current signal that occurs when an arc occurs in the power line.

In one embodiment, the arc monitoring part can acquire a preset number of intensity samples of the high-frequency current signal based on each of the first to fourth time points, average the acquired samples for each time point to calculate an average signal intensity for each time point, and detect a pattern in which the calculated average signal intensity for each time point changes as the signal intensity change pattern.

In one embodiment, the control part can distinguish, when the signal intensity change pattern matches the pre-stored arc pattern, whether a signal intensity change pattern detected from the high-frequency current signal for a predetermined time period matches the pre-stored arc pattern by a preset number of times, and distinguish the insulation state of the power line based on a result of the distinction.

In one embodiment, the insulation monitoring result received from the arc monitoring part can include magnitudes of frequency components included in at least one preset frequency band among frequency components of the high-frequency current signal detected from the power line, wherein the control part monitors the insulation state of the power line based on the magnitudes of the frequency components included in the insulation monitoring result.

In one embodiment, the arc monitoring part can include a high frequency current transformer (HFCT) that detects the high-frequency current signal from the power line, a fast Fourier transformer (FFT) that decomposes the high-frequency current signal into a magnitude for each frequency component, a memory including information on at least one frequency band related to a high-frequency current signal generated when an arc occurs, and an arc monitoring control part that detects at least one or more frequency components included in at least one frequency band stored in the memory from among each frequency component of the decomposed high-frequency current signal, and transmits the insulation monitoring result including the magnitudes of the detected frequency components to the control part.

In one embodiment, the insulation monitoring part can transmit, when a polarity of a pulse signal applied to the power line is reversed, a notification signal notifying the polarity reversal to the control part, and transmit, when the insulation resistance corresponding to the pulse signal whose polarity is reversed is calculated, the calculated insulation resistance to the control part.

In one embodiment, the control part can monitor, when the notification signal is received from the insulation monitoring part, an insulation state of the power line based on the insulation monitoring result received from the arc monitoring part until the insulation resistance calculated by the insulation monitoring part is received, and monitor, when the insulation resistance is received, the insulation state of the power line based on the insulation monitoring result received from the insulation monitoring part.

In one embodiment, the circuit breaker can include at least one semiconductor switch including a source terminal connected to a power source side of the power line, a drain terminal connected to a load side of the power line, and a gate terminal electrically connecting between the source terminal and the drain terminal based on a gate voltage applied thereto, and a gate driver applying the gate voltage to the gate terminal, wherein the control part controls the gate driver to apply a gate voltage below a preset threshold voltage based on an insulation monitoring result received from at least one of the arc monitoring part and the insulation monitoring part.

In order to achieve the foregoing objectives, a control method for an insulation monitoring system according to an embodiment of the present disclosure can include transmitting, by the insulation monitoring part, when the polarity of the pulse signal applied to the power line is reversed to calculate the insulation resistance, a notification signal notifying the polarity reversal of the pulse signal to the circuit breaking part, receiving, by the circuit breaking part, when the notification signal is received, a first insulation monitoring result related to the occurrence of the arc from the arc monitoring part, distinguishing, by the circuit breaking part, an insulation state of the power line based on the first insulation monitoring result, disconnecting, by the circuit breaking part, when insulation damage is detected as a result of the insulation state distinction based on the first insulation monitoring result, the load from the power line, calculating, by the insulation monitoring part, while the circuit breaking part distinguishes the insulation state of the power line based on the first insulation monitoring result, an insulation resistance and transmitting the calculated insulation resistance to the circuit breaking part, receiving, by the circuit breaking part, when insulation damage is not detected as a result of the insulation state distinction based on the first insulation monitoring result, the insulation resistance and re-distinguishing the insulation state of the power line based on the received insulation resistance, and disconnecting, by the circuit breaking part, the load from the power line according to a result of the re-distinction.

In one embodiment, the distinguishing, by the circuit breaking part, of an insulation state of the power line based on the first insulation monitoring result can include receiving, by the circuit breaking part, a signal intensity change pattern of a high-frequency current signal detected in the power line from the arc monitoring part, and distinguishing, by the circuit breaking part, whether the received signal intensity change pattern matches a pre-stored arc pattern, wherein the signal intensity change pattern is a pattern according to an intensity change of a high-frequency current signal detected at each of a second time point between a first time point at which an AC current flowing in the power line reaches a zero crossing point (ZCP), and a third time point corresponding to a 1/4 cycle of the AC current, and a fourth time point between the third time point and a time point at which it reaches the ZCP again, and the arc pattern is a pattern corresponding to a phased signal intensity change of a high-frequency current signal that occurs when an arc occurs in the power line.

In one embodiment, the distinguishing, by the circuit breaking part, of an insulation state of the power line based on the first insulation monitoring result can include further detecting, by the circuit breaking part, when the signal intensity change pattern matches the pre-stored arc pattern, signal intensity change patterns of the high-frequency current signal for a predetermined time period, detecting, by the circuit breaking part, a number of times that the signal intensity change patterns detected for the predetermined time period match the arc pattern, and distinguishing, by the circuit breaking part, the insulation state of the power line based on whether the detected number of times reaches a preset number of times.

In one embodiment, the distinguishing, by the circuit breaking part, of an insulation state of the power line based on the first insulation monitoring result can include receiving, by the circuit breaking part, magnitudes of at least one or more preset frequency components from the arc monitoring part, and distinguishing, by the circuit breaking part, the insulation state of the power line based on the received magnitudes of frequency components, wherein the magnitudes of frequency components received from the arc monitoring part are frequency components extracted by the arc monitoring part based on at least one frequency band related to an occurrence of an arc from among the frequency components of a high-frequency current signal detected from the power line.

In order to achieve the foregoing and other objectives, according to an aspect of the present disclosure, an insulation monitoring device according to an embodiment of the present disclosure can include an arc monitoring part that detects a high-frequency current signal from a power line connecting between a power source and a load and collects an analysis result of analyzing the detected high-frequency current signal, an insulation monitoring part that calculates an insulation resistance between the power line and the ground, a circuit breaking part for interrupting a connection between the power source and the load, and a control part that allows the insulation monitoring part to distinguish an insulation state of the power line using either an analysis result of the high-frequency current signal or the insulation resistance, depending on a polarity reversal time period after a voltage polarity of a pulse signal applied to the power line is reversed until the voltage polarity is reversed again, an initial waiting time period after the voltage polarity of the pulse signal is reversed until initial sampling is performed, and whether the insulation resistance is calculated in order to calculate the insulation resistance, and controls the circuit breaking part to disconnect a connection between the power source and the load according to a result of the distinction.

According to one embodiment, the analysis result of analyzing the high-frequency current signal can include a signal intensity change pattern of the high-frequency current signal detected from the power line, wherein the control part distinguishes the insulation state of the power line based on whether the signal intensity change pattern matches a pre-stored arc signal intensity change pattern.

According to one embodiment, the signal intensity change pattern can be a pattern according to an intensity change of a high-frequency current signal detected at each of a second time point between a first time point at which an AC current flowing in the power line reaches a zero crossing point (ZCP), and a third time point corresponding to a 1/4 cycle of the AC current, and a fourth time point between the third time point and a time point at which it reaches the ZCP again, wherein the arc signal intensity change pattern is a pattern corresponding to a phased signal intensity change of a high-frequency current signal that occurs when an arc occurs in the power line.

In one embodiment, the arc monitoring part can acquire a preset number of intensity samples of the high-frequency current signal based on each of the first to fourth time points, average the acquired samples for each time point to calculate an average signal intensity for each time point, and detect a pattern in which the calculated average signal intensity for each time point changes as the signal intensity change pattern.

In one embodiment, the control part can distinguish, when the signal intensity change pattern matches the pre-stored arc signal intensity change pattern, the insulation state of the power line based on a result of distinguishing whether a signal intensity change pattern detected from the high-frequency current signal for a predetermined time period matches the pre-stored arc signal intensity change pattern by a preset number of times.

In one embodiment, the analysis result of analyzing the high-frequency current signal can include magnitudes of frequency components detected based on at least one preset frequency band among frequency components of the high-frequency current signal detected from the power line, wherein the control part monitors the insulation state of the power line based on the magnitudes of the detected frequency components.

In one embodiment, the arc monitoring part can include a high frequency current transformer (HFCT) that detects the high-frequency current signal from the power line, and a fast Fourier transformer (FFT) that decomposes the high-frequency current signal into a magnitude for each frequency component.

According to one embodiment, the control part can control, when the initial waiting time period has elapsed, the insulation monitoring part to calculate an insulation resistance, and distinguish an insulation state of the power line based on the calculated insulation resistance, and distinguish, when the insulation resistance has been calculated, the insulation state of the power line based on the analysis result of analyzing the high-frequency current signal received from the arc monitoring part after the voltage polarity of the pulse signal is reversed again until the initial waiting time period has elapsed again for the pulse signal whose voltage polarity has been reversed.

In one embodiment, the circuit breaker can include at least one semiconductor switch including a source terminal connected to a power source side of the power line, a drain terminal connected to a load side of the power line, and a gate terminal electrically connecting between the source terminal and the drain terminal based on a gate voltage applied thereto, and a gate driver applying the gate voltage to the gate terminal, and the control part can control the gate driver to apply a gate voltage below a preset threshold voltage based on either one of an analysis result of the high-frequency current signal and the insulation resistance.

In order to achieve the foregoing or other objectives, according to an aspect of the present disclosure, a method of controlling an insulation monitoring device according to an embodiment of the present disclosure can include checking whether a first condition that is satisfied depending on whether a time period required from a time point at which a predetermined magnitude of a pulse signal having a positive or negative voltage is applied to a power line has elapsed a preset initial waiting time period and a second condition that is satisfied depending on whether an insulation resistance has been calculated are both satisfied, distinguishing, when neither of the first and second conditions is satisfied, whether an arc has occurred in the power line based on a high-frequency current signal detected from the power line until both the first and second conditions are satisfied, calculating, as a result of distinguishing whether an arc has occurred, when both the first and second conditions are satisfied while an arc has not occurred, an insulation resistance between the power line and the ground, distinguishing, when the insulation resistance is calculated, an insulation state of the power line based on the calculated magnitude of the insulation resistance, and repeatedly performing checking whether both the first and second conditions are satisfied based on a result of the insulation state distinction and distinguishing the insulation state of the power line based on the magnitude of the insulation resistance.

In one embodiment, the distinguishing of whether an arc has occurred can further include interrupting, when it is distinguished as a result of the distinction of whether an arc has occurred that an arc has occurred, an electrical connection between the power source and the load, and the distinguishing of the insulation state can further include interrupting an electrical connection between the power source and the load when the insulation of the power line is damaged.

In one embodiment, the checking of whether both the first and second conditions are satisfied can further include checking whether a polarity reversal time period of a preset pulse signal has elapsed, and reversing, when the polarity reversal time period has elapsed, a voltage polarity of the pulse signal, wherein when the polarity reversal time period has elapsed, the required time period is initialized.

In one embodiment, the distinguishing of whether an arc has occurred in the power line can include detecting a signal intensity change pattern of a high-frequency current signal detected in the power line, and distinguishing whether the arc has occurred based on whether the detected signal intensity change pattern matches a pre-stored arc signal intensity change pattern, wherein the signal intensity change pattern is a pattern according to an intensity change of a high-frequency current signal detected at each of a second time point between a first time point at which an AC current flowing in the power line reaches a zero crossing point (ZCP), and a third time point corresponding to a 1/4 cycle of the AC current, and a fourth time point between the third time point and a time point at which it reaches the ZCP again, and the arc signal intensity change pattern is a pattern corresponding to a phased signal intensity change of a high-frequency current signal that occurs when an arc occurs in the power line.

In one embodiment, the distinguishing of whether an arc has occurred based on the detected signal intensity change pattern can further include re-detecting, when the signal intensity change pattern matches the pre-stored arc signal intensity change pattern, signal intensity change patterns of the high-frequency current signal for a predetermined time period, detecting a number of times that the re-detected signal intensity change patterns match the arc signal intensity change pattern, and distinguishing whether the arc has occurred based on whether the detected number of times reaches a preset number of times.

In one embodiment, the distinguishing of whether an arc has occurred in the power line can include performing a fast Fourier transform on the high-frequency current signal to decompose the high-frequency current signal into each frequency component, detecting frequency components included in at least one pre-stored frequency band from among each of the decomposed frequency components, and distinguishing whether the arc has occurred based on the magnitudes of the detected frequency components.

### Advantageous Effects of Invention

An insulation monitoring system according to the present disclosure and the effects of the insulation monitoring system will be described as follows.

According to at least one of embodiments of the present disclosure, the present disclosure can include an insulation monitoring part that calculates an insulation resistance of a power line and an arc monitoring part that can detect an arc that occurs when the insulation breakdown of the power line occurs, thereby having an effect of detecting an insulation state of the power line through the insulation resistance of the power line and simultaneously detecting whether an arc has occurred in the power line.

Furthermore, according to at least one of embodiments of the present disclosure, the present disclosure can monitor whether an arc has occurred in a power line through the arc monitoring part during the voltage stabilization period required until the insulation resistance is calculated by the insulation monitoring part to monitor the insulation state of the power line, and monitor, when the voltage stabilization period is completed and the insulation resistance is calculated by the insulation monitoring part, the insulation state of the power line based on the calculated insulation resistance, thereby having an effect of allowing the insulation state of the power line to be continuously monitored without an idle period.

In addition, according to at least one of embodiments of the present disclosure, the present disclosure can include a semiconductor circuit breaker including a power semiconductor to allow a control part of the semiconductor circuit breaker to control the semiconductor circuit breaker according to insulation state information received from the arc monitoring part and the insulation monitoring part, thereby controlling an electrical connection to the power line at a higher speed. Accordingly, it has an effect of more effectively preventing damage to a power apparatus or an occurrence of a safety accident caused by insulation breakdown.

According to at least one of embodiments of the present disclosure, the present disclosure has an effect capable of monitoring both an insulation state of a power line and whether an arc has occurred using a single device, without installing an arc monitoring device separately from an insulation monitoring device.

Moreover, according to at least one of embodiments of the present disclosure, the present disclosure has an effect of minimizing a time period in which insulation monitoring is not performed by allowing the insulation monitoring device to monitor the insulation state of the power line through the arc monitoring during a time period in which the insulation monitoring device is unable to monitor the insulation state of the power line.

### Brief Description of Drawings

FIG. 1 is a block diagram showing a configuration of an insulation monitoring system according to an embodiment of the present disclosure.
FIG. 2A is a block diagram showing a configuration of an arc monitoring part that monitors an AC arc in an insulation monitoring system according to an embodiment of the present disclosure.
FIG. 2B is an exemplary diagram showing an example of a high-frequency current signal detected by an arc monitoring part while an arc has occurred according to an embodiment of the present disclosure.
FIG. 3 is a block diagram showing a configuration of an arc monitoring part that monitors a DC arc in an insulation monitoring system according to an embodiment of the present disclosure.
FIG. 4 is a block diagram showing a configuration of an insulation monitoring part in an insulation monitoring system according to an embodiment of the present disclosure.
FIG. 5 is a block diagram showing a configuration of a circuit breaking part in an insulation monitoring system according to an embodiment of the present disclosure.
FIG. 6 is a flowchart showing an operation process in which an arc monitoring part, an insulation monitoring part, and a circuit breaking part are linked in an insulation monitoring system according to an embodiment of the present disclosure.
FIG. 7 is a flowchart showing an operation process of a circuit breaking part that performs insulation monitoring using an arc monitoring part and an insulation monitoring part according to a voltage stabilization period in an insulation monitoring system according to an embodiment of the present disclosure.
FIG. 8 is an exemplary diagram showing an example in which insulation monitoring is performed based on whether an arc occurs and an insulation resistance according to the voltage stabilization period according to the operation process of FIG. 7.
FIG. 9 is a flowchart showing an another operation process in which an arc monitoring part, an insulation monitoring part, and a circuit breaking part are linked in an insulation monitoring system according to an embodiment of the present disclosure.
FIG. 10 is a flowchart showing another operation process of a circuit breaking part that performs insulation monitoring using an arc monitoring part and an insulation monitoring part according to a voltage stabilization period in an insulation monitoring system according to an embodiment of the present disclosure.
FIG. 11A is a block diagram showing a configuration of an insulation monitoring device according to an embodiment of the present disclosure.
FIG. 11B is a conceptual diagram showing an example in which an arc monitoring part and an insulation monitoring part of an insulation monitoring device according to an embodiment of the present disclosure are connected to a power line.
FIG. 12A is a block diagram showing components of an arc monitoring part according to an embodiment of the present disclosure.
FIG. 12B is a block diagram showing components of an insulation monitoring part according to an embodiment of the present disclosure.
FIG. 13 is a block diagram showing a detailed configuration of a circuit breaking part of an insulation monitoring device according to an embodiment of the present disclosure.
FIG. 14 is a flowchart showing an operation process of an insulation monitoring device according to an embodiment of the present disclosure.
FIG. 15A is a flowchart showing an operation process of an arc monitoring part that monitors an AC arc during the operation process of an insulation monitoring device according to an embodiment of the present disclosure.
FIG. 15B is an exemplary diagram showing an example of a high-frequency current signal detected by an arc monitoring part while an arc has occurred according to an embodiment of the present disclosure.
FIG. 16 is a flowchart showing an operation process of an arc monitoring part that monitors a DC arc during the operation process of an insulation monitoring device according to an embodiment of the present disclosure.
FIG. 17 is a conceptual diagram for explaining that arc monitoring and insulation monitoring are performed by an insulation monitoring device according to an embodiment of the present disclosure.

### Mode for the Invention

It should be noted that the technical terms used herein are merely used to describe a specific embodiment, but are not intended to limit the present disclosure. In addition, a singular expression used herein can include a plural expression unless clearly defined otherwise in the context. A suffix "module" or "part" used for elements disclosed in the following description is merely intended for easy description of the specification, and the suffix itself is not intended to have any special meaning or function.

As used herein, terms such as "comprise" or "include" should not be construed to necessarily include all elements or steps described herein, and should be construed not to include some elements or some steps thereof, or should be construed to further include additional elements or steps.

In addition, in describing technologies disclosed herein, when it is determined that a detailed description of known technologies related thereto can unnecessarily obscure the subject matter disclosed herein, the detailed description will be omitted.

Furthermore, the accompanying drawings are provided only for a better understanding of the embodiments disclosed in this specification and are not intended to limit technical concepts disclosed in this specification, and therefore, it should be understood that the accompanying drawings include all modifications, equivalents and substitutes within the concept and technical scope of the present disclosure. In addition, not only individual embodiments described below but also a combination of the embodiments may, of course, fall within the concept and technical scope of the present disclosure, as modifications, equivalents or substitutes included in the concept and technical scope of the present disclosure.

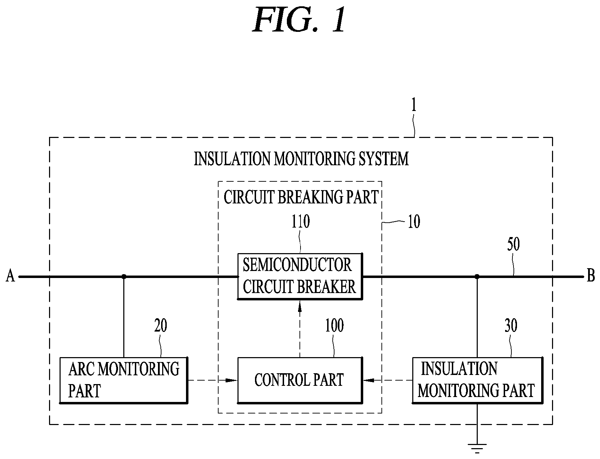

First, FIG. 1 is a block diagram showing a configuration of an insulation monitoring system according to an embodiment of the present disclosure.

Referring to FIG. 1, an insulation monitoring system 1 according to an embodiment of the present disclosure can be configured to include an insulation monitoring part 30 that monitors an insulation state of a power line 50, an arc monitoring part 20 that monitors whether an arc occurs in the power line 50 based on a high-frequency current signal, and a circuit breaking part 10 that disconnects a connection between the power line 50 and a load based on an interruption signal received from the insulation monitoring part 30 and the arc monitoring part 20. Here, the power line 50 can be an electric path through which power is supplied from an ungrounded (insulation terra (IT)) power system.

The circuit breaking part 10 can be provided on a power line connecting between a power source and a load or a power line connecting between systems. That is, when a left side of the circuit breaking part 10, that is, A, is connected to the power source in FIG. 1, a right side of the circuit breaking part 10, that is, B, can be connected to the load. Conversely, when the right side B of the circuit breaking part 10 is connected to the power source in FIG. 1, the left side A of the circuit breaking part 10 can be connected to the load. In this case, when one side is the power source and the other side is the load, a unidirectional current flow can be formed. Additionally, the A and B can be different power systems, such as different micro grids, in which case a bidirectional current flow can be formed not only from system A to system B, but also from system B to system A.

In order to connect or interrupt such a unidirectional or bidirectional current flow, the circuit breaking part 10 can include a semiconductor circuit breaker 110 including at least one semiconductor switch. In addition, the circuit breaking part 10 can include a control part 100 for controlling the semiconductor circuit breaker 110.

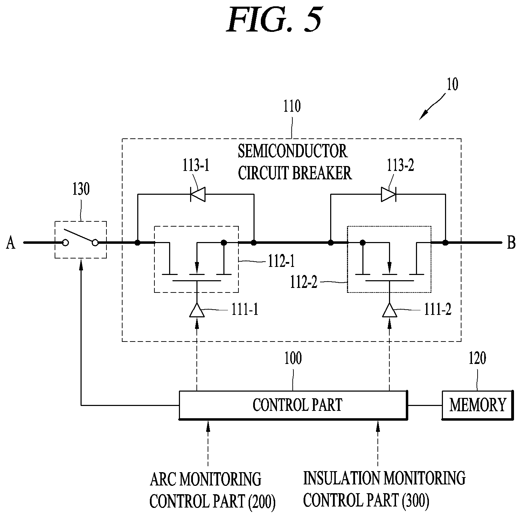

The control part 100 can be connected to the insulation monitoring part 30 and the arc monitoring part 20 by wired or wireless communication, and can receive a monitoring result from at least one of the insulation monitoring part 30 and the arc monitoring part 20 through the communication connection. Furthermore, based on the received monitoring result, the semiconductor circuit breaker 110 can be controlled to perform an interruption operation. Accordingly, depending on the monitoring result of either the arc monitoring part 20 or the insulation monitoring part 30, the load can be disconnected from the power line 50, or another system (e.g., system B) can be disconnected from a system in which the insulation has been broken (e.g., system A). An operation process of the circuit breaking part 10 according to an embodiment of the present disclosure will be described in more detail with reference to FIG. 5 below.

Alternatively, the control part 100 can control the arc monitoring part 20 and the insulation monitoring part 30 connected thereto. For example, the control part 100 can distinguish whether the insulation monitoring part 30 is in a state capable of calculating an insulation resistance based on a state of the insulation monitoring part 30. Furthermore, when the insulation monitoring part 30 is unable to monitor the insulation state of the power line 50, the arc monitoring part 20 can be controlled to monitor whether the insulation of the power line 50 is broken by determining whether an arc occurs.

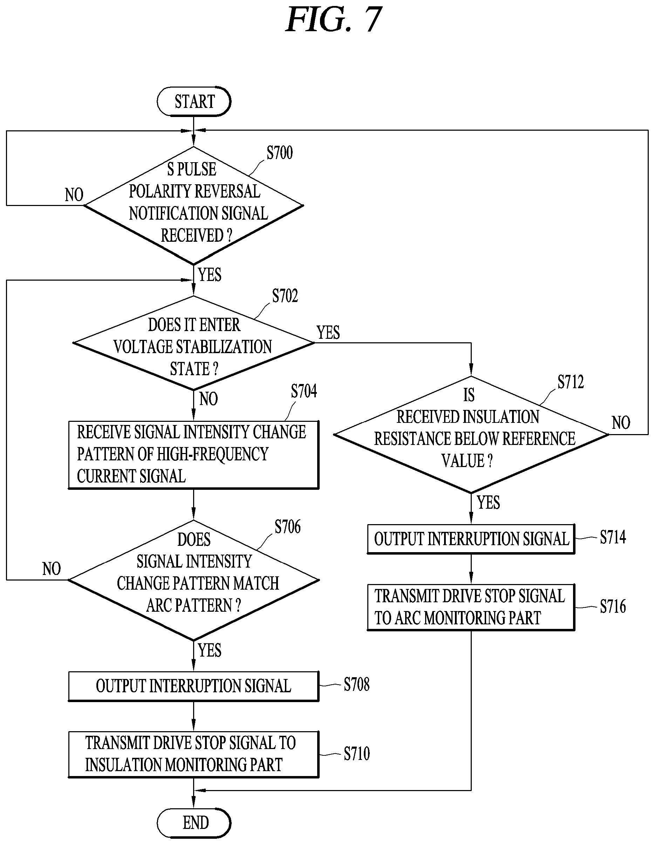

Meanwhile, as a result of distinguishing the state of the insulation monitoring part 30, when the insulation monitoring part 30 is capable of calculating the insulation resistance, the control part 100 can also monitor the insulation state of the power line 50 based on the insulation resistance calculated by the insulation monitoring part 30. In this case, during a time period in which the insulation monitoring part 30 is unable to monitor the insulation state of the power line 50, such as a voltage stabilization time period, whether the insulation of the power line 50 is broken can be monitored based on a monitoring result of the arc monitoring part 20, and when the insulation monitoring part 30 is able to monitor the insulation state of the power line 50 through the calculated insulation resistance, the insulation state of the power line 50 can be monitored through a monitoring result of the insulation monitoring part 30, that is, the insulation resistance. That is, the insulation state of the power line 50 can be monitored without an idle period in which the insulation state is not detected. The operation process of the circuit breaking part 10 according to an embodiment of the present disclosure will be described in more detail with reference to FIG. 7 below.

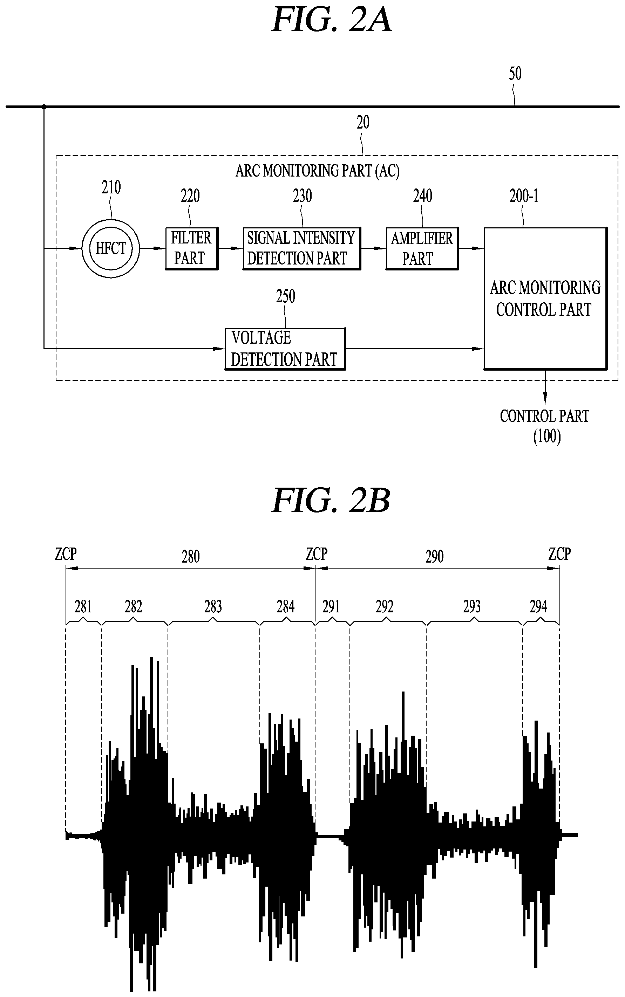

Hereinafter, a more detailed configuration of the arc monitoring part 20, the insulation monitoring part 30, and the circuit breaking part 10 will be described with reference to FIGS. 2A to 4.

First, FIG. 2A is a block diagram showing a configuration of the arc monitoring part 20 of the insulation monitoring system 1 according to an embodiment of the present disclosure. FIG. 2A shows an example of the arc monitoring part 20 that detects an arc based on partial discharging that occurs during insulation breakdown when the power line 50 is an electric path through which an AC current flows. Furthermore, FIG. 2B is an exemplary diagram showing an example of a high-frequency current signal detected by an arc monitoring part while an arc has occurred according to an embodiment of the present disclosure.

First, referring to FIG. 2A, the arc monitoring part 20 can be formed to include a high frequency current transformer (HFCT) 210 that detects a high-frequency current signal, a filter part 220 for frequency filtering, a signal intensity detection part (power detector) 230 that detects a signal intensity of the high-frequency current signal, an amplifier part 240 that amplifies a signal level of the high-frequency current signal detected by the signal intensity detection part 230 into a signal with a magnitude that can be identified by an arc monitoring control part 200-1, and the arc monitoring control part 200-1. Additionally, it can include a voltage detection part 250 for detecting a voltage change of the power line 50.

More specifically, the HFCT 210 can detect a high-frequency current signal from the power line 50. The high-frequency current signal, which is a signal in a high-frequency band generated by partial discharge caused by an arc, can also be referred to as a high-frequency noise signal.

Furthermore, the filter part 220 can be a filter that filters a specific frequency using a frequency mask method. Here, the specific frequency can be a frequency corresponding to living noise, noise generated when driving a load, or electromagnetic compatibility (EMC) noise. The filter part 220, which is a filter that filters a signal in at least one different frequency band that is designated in advance, can remove noise whose frequency band is known in advance, such as living noise, load driving noise, and EMC noise.

The signal intensity detection part 230 can detect an intensity of the high-frequency current signal detected through the HFCT 210. As an example, the signal intensity detection part 230 can convert the high-frequency current signal detected by the HFCT 210 into a voltage signal corresponding to its magnitude. Here, since the high-frequency current signal converted into the voltage signal can be an analog signal, the signal intensity detection part 230 can further include an analog digital converter (ADC) for converting the high-frequency current signal in the analog form into a digital signal. Therefore, the high-frequency current signal converted into the voltage signal can be converted into a digital signal having different values depending on the signal intensity through the signal intensity detection part 230.

The amplifier 240 can receive a digital signal input from the signal intensity detection part 230, and amplify the received digital signal into a signal with a level that can be identified by the arc monitoring control part 200-1. Here, the amplifier 240 can be an inverting amplifier that inverts a phase of an input signal and amplifies the inverted signal phase as a voltage gain has a negative (-) value, or a non-inverting amplifier that amplifies only a magnitude of an input signal while maintaining the phase of the input signal as it is as a voltage gain has a positive (+) value.

Meanwhile, the voltage detection part 250 can detect a voltage change in the power line 50. In this case, when a current flowing in the power line 50 is a single-phase current, the current flowing in the power line can be a current in which a positive (+) voltage and a negative (-) voltage periodically change according to a cycle of the single-phase current. Therefore, a voltage change in which the positive (+) voltage and negative (-) voltage periodically change can be detected through the voltage detection part 150 and provided to the arc monitoring control part 200-1.

Meanwhile, the arc monitoring control part 200-1 can control each component connected thereto, and control an overall operation of the arc monitoring part 20. Meanwhile, the arc monitoring control part 200 can detect a time point at which a voltage changes from a positive (+) value to a negative (-) value, or a time point at which the voltage changes from a negative value to a positive value, based on a voltage change detected through the voltage detection part 250, that is, a zero crossing point.

Furthermore, the arc monitoring control part 200-1 can receive a high-frequency current signal amplified through the amplifier part 240. Furthermore, a change in the high-frequency current signal intensity over time can be detected. In addition, the arc monitoring control part 200-1 can detect a change in the high-frequency current signal intensity corresponding to a half cycle of a current flowing in the power line 50 based on the zero crossing points detected through the voltage detection part 150. Furthermore, depending on a pattern indicated by the change in the high-frequency current signal intensity during the detected half-cycle, it can be distinguished whether an arc has occurred in the power line 50 during the half-cycle.

For example, when an arc occurs, the high-frequency current signal can have a periodic characteristic in which the signal intensity increases and decreases according to a periodic characteristic (e.g., zero crossing point) of the single-phase current.

That is, when an insulation between adjacent electric paths is damaged or destroyed, or a crack occurs in an electric path due to aging or damage of the electric path, a voltage difference occurs between points of the insulation damage or insulation destruction, or between two contacts (hereinafter referred to as arc contacts) of the electric path that is short-circuited by the crack, and a discharge phenomenon, that is, an arc, occurs due to the occurred voltage difference.

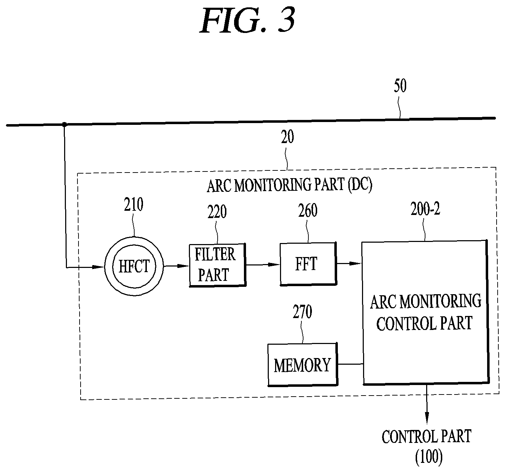

Referring to FIG. 3, turning to a periodic characteristic in which an arc occurs and extinguishes, the arc can have a periodic characteristic in which an arc does not occur (no arc phase (no arcing)) 281, 291 as a voltage difference between the arc contacts is small, an arc strike phase 282, 292 in which an arc begins to occur at the arc contacts as the voltage difference between the arc contacts increases, an arc conduct phase 283, 293 in which a current is conducted between the arc contacts through a current discharged from the arc contacts as the voltage difference between the arc contacts reaches a maximum value, and an arc quenches phase 284, 294 in which the arc is extinguished as the voltage difference between the arc contacts decreases.

In this case, an intensity of the high-frequency current signal can be different in each of the no arc phase 281, 291, the arc strike phase 282, 292, the arc conduct phase 283, 293 and the arc quenches phase 284, 294. For example, the arc strike phase 282, 292 and the arc quenches phase 284, 294 can be phases where no current is conducted despite having a large voltage, so the voltage difference between the arc contacts is large and thus the arc is the largest. That is, it can be a phase where the high-frequency current signal is generated most strongly.

Additionally, the arc conduct phase 283, 293, which is a phase where a current is conducted between the arc contacts due to an arc discharge, can be a phase where the arc is reduced due to current conduction despite having the largest voltage according to the periodic characteristic of the single-phase current. That is, it can be a phase where the intensity of the high-frequency noise current signal decreases. In addition, the no arc phase 281, 291, which is a phase where an arc does not occur or extinguishes due to a small voltage difference between the arc contacts, can be a phase where the intensity of the high-frequency current signal is the weakest because the arc is the least.

Therefore, a maximum high-frequency current signal can be generated in the arc strike phase 282, 292 and the arc quenches phase 284, 294, a signal smaller than the maximum high-frequency current signal can be generated in the arc conduct phase 282, 292, and a high-frequency current signal weaker than the high-frequency current signal generated in the arc conduct phase can be generated in the no arc phase 281, 291.

That is, when the intensity of the high-frequency current signal generated in the no arc phase 281, 291 is referred to as a first signal intensity, a high-frequency current signal with a second signal intensity stronger than the first signal intensity is generated in the arc conduct phase 283, 293, and a high-frequency current signal with a third signal intensity stronger than the second signal intensity is generated in the arc strike phase 282, 292 and the arc quenches phase 284, 294.

Meanwhile, when the insulation is broken, a no arc phase - arc strike phase - arc conduct phase - arc quenches phase - no arc phase is repeated between a zero crossing point (ZCP) and a ZCP of the single-phase current, that is, during a half cycle of the single-phase current, and thus the intensity of the high-frequency current signal can also have a change pattern. Furthermore, the arc monitoring control part 200-1 can detect whether an arc has occurred due to insulation breakdown in the power line 50 based on a signal intensity change pattern of the high-frequency current signal. Here, the ZCP, which is a time point at which the polarity is reversed according to the periodic characteristics of the AC current, refers to a time point at which the voltage is 0.

To this end, the arc monitoring control part 200-1 can determine a sampling time point at which to sample a preset number of high-frequency current signal samples between a ZCP and a ZCP (a half cycle) of the single-phase current. For example, the arc monitoring control part 200-1 can acquire a preset number of samples from a time point corresponding to the ZCP.

In this case, the arc monitoring control part 200-1 can acquire a preset number of samples (first samples) based on a time point corresponding to the half cycle (ZCP) of the single-phase current. Furthermore, based on a time point corresponding to a 1/8 cycle of single-phase current, the preset number of samples (second samples) can be acquired. Additionally, a preset number of samples (third samples) can be acquired based on a time point corresponding to a 2/8 cycle (1/4 cycle) of the single-phase current, that is, a time point with a maximum voltage. Lastly, a preset number of samples (fourth samples) can be acquired again based on a time period corresponding to a 3/8 cycle of the single-phase current. Here, the foregoing sampling time points are merely examples to help the description of the present disclosure, and the present disclosure is not limited thereto. Furthermore, the arc monitoring control part 200-1 can calculate signal intensity averages for each of the acquired preset numbers of samples. Therefore, a signal average of the first samples (first signal intensity average), a signal average of the second samples (second signal intensity average), a signal average of the third samples, and a signal average of the fourth samples (third signal intensity average and fourth signal intensity average) can be calculated, respectively.

Here, the first samples can be samples acquired in the no arc phase 281, 291, and the second samples can be samples acquired in the arc strike phase 282, 292. Additionally, the third samples can be samples 283, 293 acquired in the arc conduct phase, and the fourth samples can be samples acquired in the arc quenches phase 284, 294.

Therefore, the first signal intensity average can be a signal intensity average of the samples acquired in the no arc phase 281, 291. Furthermore, the second signal intensity average can be a signal intensity average of samples acquired in the arc strike phase 282, 292, and the third signal intensity average and the fourth signal intensity average can be signal intensity averages of samples acquired in the arc conduct phase 283, 293 and the arc quenches phase 284, 294, respectively.

Then, the arc monitoring control part 200-1 can detect an intensity change pattern of a high-frequency current signal from the signal intensity averages in the each arc phase. For example, the arc monitoring control part 200-1 can detect a change in the signal intensity average when the cycle of the single-phase current proceeds from a ZCP time point to a 1/8 cycle time point by comparing the first signal intensity average with the second signal intensity average. Furthermore, the control part 1100 can detect a change in the signal intensity average when the cycle of the single-phase current proceeds from a 1/8 cycle time point to a 2/8 cycle (1/4 cycle) time point by comparing the second signal intensity average with the third signal intensity average. In the same way, the control part 1100 can detect a change in the signal intensity average when the cycle of the single-phase current proceeds from a 2/8 cycle time point to a 3/8 cycle time point and from the 3/8 cycle time point to a 4/8 cycle (half cycle, i.e. ZCP) time point by comparing the third signal average with the fourth signal average and comparing the fourth signal average with the first signal average of the next cycle.

Here, when an arc occurs, the intensity of the high-frequency current signal can be weakest in the no arc phase (around the ZCP) 281, and then increase while entering the arc strike phase 282. Furthermore, while passing through the arc strike phase 282 to enter the arc conduct phase (maximum voltage state, 1/4 cycle) 283, a current is conducted to reduce the intensity of the high-frequency current signal again. Furthermore, as the current conduction is discontinued while entering the arc quenches phase 284 from the arc conduct phase 283, the intensity of the high-frequency current signal can increase again, and the intensity of the high-frequency current signal can weaken again while entering the no arc phase 291, which is a ZCP state.

Therefore, when an arc occurs, a change in the signal intensity average can increase when proceeding from the first signal average to the second signal average, decrease when proceeding from the second signal average to the third signal average, increase again when proceeding from the third signal average to the fourth signal average, and decrease again when proceeding from the fourth signal average to the first signal average of the next cycle. That is, a change pattern of the signal intensity average has a pattern of increase - decrease - increase - decrease, and can have a characteristic in which the intensity of the third signal intensity average is greater than that of the first signal intensity average.

Accordingly, the arc monitoring control part 200-1 can determine that a pattern corresponding to an occurrence of an arc has been formed when a change pattern of the signal intensity average and a feature (a feature in which the intensity of the third signal intensity average is greater than that of the first signal intensity average) are detected.

Then, the arc monitoring control part 200-1 can transmit a result of distinguishing whether an arc has occurred according to the pattern of the high-frequency current signal to the control part 100 of the circuit breaking part 10. Then, the control part 100 can control the semiconductor circuit breaker 110 based on the result of distinguishing whether an arc has occurred, thereby interrupting an electrical connection to the power line 50.

Here, the arc monitoring control part 200 can, of course, transmit, as a result of distinguishing whether an arc has occurred, an interruption signal to the control part 100 to operate the semiconductor circuit breaker 110 only when an arc has occurred. Alternatively, the arc monitoring control part 200 can transmit signal intensity pattern information analyzed by each of the acquired samples, that is, signal intensity pattern information including the first to third steps, to the control part 100, and the control part 100 can, of course, distinguish whether an arc has occurred based on the received signal intensity pattern information.

Meanwhile, the arc monitoring control part 200-1 or the control part 100 can, of course, distinguish whether an arc has occurred based on whether a change pattern of the signal intensity average matching the arc occurrence pattern is detected by a preset number of times over a predetermined time period in order to more accurately distinguish whether an arc has occurred. In this case, when a change pattern of the signal intensity average corresponding to the arc pattern is detected by the preset number of times over the predetermined time period, the arc monitoring control part 200-1 or the control part 100 can distinguish that an arc has occurred.

Meanwhile, as shown above, FIG. 2A shows an example in which a single-phase current, that is, an AC current, flows in the power line 50. However, when a DC current flows through the power line 50, the DC current does not have ZCP, so it can be difficult to distinguish whether an arc has occurred using the method described above in FIG. 2A.

Accordingly, when the current flowing in the power line 50 is a DC current, whether an arc has occurred from the power line 50 can be distinguished by using the arc monitoring part 20 having a different configuration from that of the arc monitoring part 20 shown in FIG. 2A. Hereinafter, the configuration of an arc monitoring part 200-2 that monitors an occurrence of an arc from a power line 50 through which a DC current flows will be described in FIG. 3 below.

Referring to FIG. 3, the arc monitoring part 20 of the insulation monitoring system 1 according to an embodiment of the present disclosure can be configured to include an HFCT 210, a filter part 220, a fast Fourier transformer (FFT) 260, an arc monitoring control part 200-2, and a memory 270 connected to the arc monitoring control part 200-2.

Here, the HFCT 210 can detect a high-frequency current signal due to partial discharge occurring in the power line 50 as described above.

Furthermore, the filter part 220, which is a filter that filters a specific frequency in a frequency mask method, can be a filter for removing noise whose frequency band is known in advance, such as living noise, load driving noise, or EMC noise as described above. Therefore, a high-frequency current signal of a power line 50 with noise such as living noise or load driving noise removed can be acquired through the HFCT 210 and the filter part 220.

Meanwhile, the FFT 260 can perform a fast Fourier transform on the high-frequency current signal of the power line 50 from which the noise has been removed. Therefore, the acquired high-frequency current signal can be decomposed into a magnitude for each frequency component. In this case, when no arc occurs in the power line 50, there can be no high-frequency current signal detected by the HFCT 210, and thus a value of 0 can be calculated as an operation result of the FFT 260. Then, the arc monitoring control part 200-2 that receives the operation result of the FFT 260 can determine that there is no arc discharge.

However, even when an arc occurs in the power line 50 or no arc occurs, various noises can occur due to arbitrary environmental factors. For example, a temporary change in the electric field can occur due to an effect such as a temporary change in the magnetic field formed nearby by lightning, and a high-frequency current signal can be generated in the power line 50 due to such a change in the electric field. Furthermore, the generated high-frequency current signal can be detected through the HFCT 210 and the filter part 220 and applied to the FFT 260. Then, the FFT 260 can decompose the input high-frequency current signal into frequency components to calculate a magnitude for each frequency component.

Then, the arc monitoring control part 200-2 can distinguish whether an arc has occurred in the power line 50 from a magnitude for each frequency component of a high-frequency current signal input from the FFT 260. For example, the arc monitoring control part 200-2 can detect whether there are magnitudes corresponding to at least one frequency component that mainly occurs during an occurrence of an arc from among magnitudes for frequency components. Furthermore, when at least one frequency component that mainly occurs during an occurrence of an arc is included in the high-frequency current signal, the magnitudes of the detected frequency components can be summed. Furthermore, when the summed magnitude is above a preset reference value, it can be distinguished that an arc has occurred. Here, information on at least one or more frequency components that mainly occur during the occurrence of the arc can be stored in the memory 270.

That is, the memory 270 includes information on at least one frequency band related to the occurrence of the arc, and the arc monitoring control part 200-2 can detect a frequency component corresponding to at least one frequency band stored in the memory 270 from among each frequency component included in the high-frequency current signal in the operation result of the FFT 260. Furthermore, whether an arc has occurred can be distinguished based on a result of comparing a value obtained by summing the magnitudes of the detected frequency components with a preset reference value.

Meanwhile, according to the foregoing description, when an AC current flows in the power line 50, the arc monitoring part 20 can have the configuration shown in FIG. 2A, and the arc monitoring part 20 can have the configuration shown in FIG. 3 when a DC current flows in the power line 50. Although the arc monitoring part 20 has been described by being divided into FIG. 2A and FIG. 3, the arc monitoring part 20 can, of course, also be formed as a single configuration. For example, the arc monitoring control part can, of course, perform both the function of the arc monitoring control part 200-1 and the function of the arc monitoring control part 200-2. In addition, the FFT 260 and the memory 270 described in FIG. 3 can be further provided in the configuration of FIG. 2A, thereby allowing both DC and AC arcs to be detected.

Accordingly, in the following description, for convenience of description, the arc monitoring control part 200-1 that can distinguish whether an arc occurs in the power line 50 for an AC current and the arc monitoring control part 200-2 that can distinguish whether an arc occurs in the power line 50 for a DC current are collectively referred to as the arc monitoring control part 200.

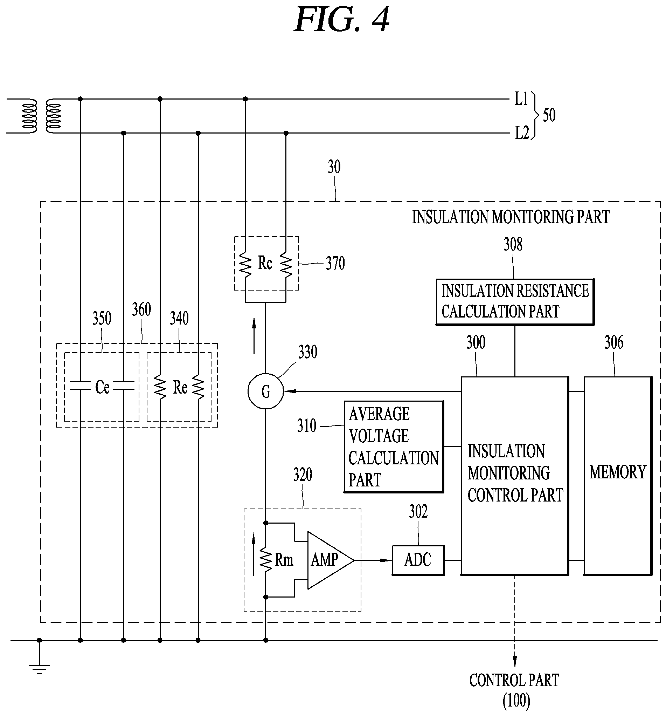

Meanwhile, FIG. 4 is a block diagram showing a configuration of the insulation monitoring part 30 of the insulation monitoring system 1 according to an embodiment of the present disclosure.

Referring to FIG. 4, the insulation monitoring part 30 of the insulation monitoring system 1 according to an embodiment of the present disclosure can be configured to include a coupler resistor Rc 370 connected to power lines (hereinafter referred to as a power line 50) of a system , a signal generation part 330 that applies a square wave pulse signal to the power line 50 through the coupler resistor 370, a virtual insulation resistance Re 340 formed between the power line 50 and the ground, a signal measurement part 320 including a detection resistor Rm connected to the ground, an analog digital converter (ADC) 302 connected to the signal measurement part 320 to convert a voltage measured by the signal measurement part 320 into a digital value, an average voltage calculating part 310 that receives the digital value converted by the ADC 302 to calculate an average voltage according to the pulse signal applied to the power line 50 during a preset sampling section, an insulation monitoring control part 300 that controls other elements connected thereto, and detects a plurality of steady-state voltages according to the applied pulse signal based on a plurality of average voltages calculated by the average voltage calculation part 310, and an insulation resistance calculation part 308 that calculates a magnitude of the insulation resistance 340 based on the plurality of steady-state voltages detected by the insulation monitoring control part 300. Furthermore, it can be configured to include a memory 306 in which various data items input to or output from the insulation monitoring control part 300 are stored.

First, the signal generation part 330 can generate a pulse signal having a constant positive (+) voltage or a constant negative (-) voltage for a preset time period under the control of the control part 300. Furthermore, the generated pulse signal can be applied to the power line 50. Accordingly, a pulse signal with alternating positive and negative voltages can be applied to the power line 50 under the control of the insulation monitoring control part 300.

Meanwhile, the power line 50 and the ground can be connected to each other through a virtual circuit. Furthermore, a virtual insulation resistance Re, 340 can be formed between the power line 50 and the ground. Additionally, a virtual capacitor Ce, 350 can be further formed between the power line 50 and the ground. Furthermore, the capacitor 350 can form an insulation impedance 360 between the power line 50 and the ground together with the insulation resistance 340.

Therefore, the pulse signal applied to the power line 50 can be input to the signal measurement part 320 through the circuit formed between the power line 50 and the ground. Then, the signal measurement part 320 can detect a voltage of the virtual circuit in which the insulation impedance is reflected based on a voltage across the two terminals of the detection resistor. The detection result of the signal measurement part 320 can be amplified through an amplifier part (Amp, Amplifier) and converted into a digital value through an ADC 302. Furthermore, it can be input to the insulation monitoring control part 300.

Furthermore, when the voltage of the virtual circuit for pulse signals of different polarities is calculated, the insulation monitoring control part 300 can control the insulation resistance calculation part 308 so that the insulation resistance is calculated based on the virtual circuit voltage of different polarities.

However, when the voltage changes from a positive voltage to a negative voltage or the polarity of the pulse signal changes from a negative voltage to a positive voltage, discharging and charging by the insulating capacitor 350 can be induced. Accordingly, a transient period occurs in which the voltage increases several times more than the applied pulse voltage, and the voltage of the virtual circuit becomes unstable. In this way, when the voltage of the virtual circuit is unstable, an accurate insulation resistance is not calculated, so the insulation monitoring control part 300 can determine a sampling interval and determine whether the virtual circuit voltage is stabilized based on the change in the virtual circuit voltage measured by the signal measurement part 320 according to the determined sampling interval.

To this end, the insulation monitoring control part 300 can detect the voltage of the virtual circuit at each sampling interval. Furthermore, by controlling the average voltage calculation part 310, the average voltage of the virtual circuit during the sampling section according to the sampling interval can be calculated. Furthermore, when the average voltage produced is less than or equal to a preset error value, it can be distinguished that the virtual circuit voltage is stabilized. Then, the insulation monitoring control part 300 can control the insulation resistance calculation part 308 to calculate a magnitude of the insulation resistance 340 based on a stabilized virtual circuit voltage (first average voltage) calculated before the polarity of the pulse signal is reversed and a stabilized virtual circuit voltage (second average voltage) calculated after the polarity of the pulse signal is reversed. That is, the magnitude of the insulation resistance 340 can be calculated after the virtual circuit voltage is stabilized. Furthermore, the insulation monitoring part 30 can control the signal generation part 330 so that the polarity of the pulse signal is reversed and perform the same process again to continuously calculate the magnitude of the insulation resistance 340.

Meanwhile, if the insulation state of the power line 50 is destroyed, the magnitude of the insulation resistance 340 of the virtual circuit can decrease. On the other hand, if the insulation state of the power line 50 is maintained, the insulation resistance 340 of the virtual circuit can have a sufficient magnitude. Accordingly, the insulation monitoring control part 300 can distinguish the insulation state of the power line 50 based on the magnitude of the calculated insulation resistance 340.

The insulation monitoring control part 300 can compare the insulation resistance magnitude with a preset reference value when the insulation resistance is calculated. Furthermore, based on the comparison results, the insulation state of the power line 50 can be distinguished. Furthermore, when it is distinguished that the insulation is broken, the control part 100 of the circuit breaking part 10 can be requested to operate the semiconductor circuit breaker 110. Then, the control part 100 of the circuit breaking part 10 can output an interruption control signal to the semiconductor circuit breaker 110 to interrupt a connection to the power line 50.

Alternatively, the insulation monitoring control part 300 can transmit the calculated insulation resistance to the control part 100 of the circuit breaking part 10. Then, the control part 100 can compare the received insulation resistance with a reference value to distinguish the insulation state of the power line 50, and of course, can drive the semiconductor circuit breaker 110 according to the distinguished insulation state.

Meanwhile, the insulation monitoring part 30 can also distinguish the insulation state of the power line for not only a DC current but also an AC current. For example, in the case of an AC current, the insulation monitoring part 30 can further include a converter (not shown) for converting the AC current of the power line 50 into a DC current. In this case, a pulse signal can be applied to the power line 50 through which an AC current flows through the converter, and an AC current detected from the power line 50 can be converted into a DC current through the converter. Furthermore, the signal measurement part 320 can detect a voltage of the converted DC current. Accordingly, the insulation monitoring part 30 can monitor an insulation state of not only a power line through which a DC current flows but also a power line through which an AC current flows.

FIG. 5 is a block diagram showing the configuration of a circuit breaking part 10 of an insulation monitoring system 1 according to an embodiment of the present disclosure.

As shown in FIG. 5, the circuit breaking part 10 can include a semiconductor circuit breaker consisting of a plurality of semiconductor switches 112-1, 112-2 connected in series to connect a bidirectional current flow. Here, the semiconductor circuit breaker 110 can be a solid state circuit breaker (SSCB) capable of high-speed current interruption.

First, the first semiconductor switch 112-1 can be a semiconductor switch in which a source terminal is connected to one end (side A) of the semiconductor circuit breaker 110 and a drain terminal is connected to the other end (side B). Furthermore, the drain terminal and the source terminal can be connected through a diode (first diode 113-1) in which the positive (+) pole is connected to the drain terminal and the negative (-) pole is connected to the source terminal. In addition, the second semiconductor switch 112-2 can be a semiconductor switch in which a source terminal is connected to the other end (side B) of the semiconductor circuit breaker 110 and a drain terminal is connected to one end (side A). Furthermore, the drain terminal and the source terminal can be connected through a diode (first diode 113-2) in which the positive (+) pole is connected to the drain terminal and the negative (-) pole is connected to the source terminal. In this way, a plurality of semiconductor switches can be connected in series to one another, each of which has a source terminal and a drain terminal connected to different ends of the semiconductor circuit breaker, the circuit breaking part 110 can be formed to control the flow of a bidirectional current flowing from side B to side A as well as flowing from side A to side B.

Meanwhile, the source and drain terminals of each of the first semiconductor switch 112-1 and the second semiconductor switch 112-2 can be connected through the gate terminal of each semiconductor switch. Each gate terminal is connected to each gate driver 111-1, 111-2, and each source terminal and drain terminal can be electrically connected based on a voltage applied to the gate terminal from the gate driver, that is, a gate voltage. In this case, when the gate voltage is above a preset threshold voltage, the source terminal and the drain terminal can be electrically connected to each other. On the other hand, when the gate voltage is below the threshold voltage or no gate voltage is applied, the source terminal and the drain terminal can not be electrically connected to each other. That is, an electrical connection between side A and side B can be disconnected.

Meanwhile, the circuit breaking part 10 can further include a circuit breaking switch (molded case circuit breaker (MCCB)) 130 to physically disconnect an electrical connection between the A side and the B side, in addition to electrical blocking using the semiconductor circuit breaker 110. In this case, the semiconductor circuit breaker 110 primarily blocks the electrical connection between the A side and the B side, and while the electrical connection between the A side and the B side is blocked by the semiconductor circuit breaker 110, the circuit breaking switch 150 physically blocks the connection between the A side and the B side, thereby more safely disconnecting a connection between the power source and the load where an abnormality has occurred.

Meanwhile, the circuit breaking part 10 can be equipped with a control part 100 for controlling the semiconductor circuit breaker 110. Furthermore, it can include a memory 120 in which data and commands supporting the operation of the control part 100 are stored.

The control part 100 controls the gate driver 111-1, 111-2 of the semiconductor circuit breaker 110 to control the gate voltage applied to the gate terminal of each semiconductor switch 112-1, 112-2, thereby controlling the semiconductor circuit breaker 110 so that the electrical connection between the A side and the B side is cut off.

Here, the control part 100 can control the semiconductor circuit breaker 110 based on an arc monitoring result received from the arc monitoring control part 200 or an insulation state monitoring result received from the insulation monitoring control part 200. In this case, the arc monitoring result can be whether an arc has occurred in the power line 50 as distinguished by the arc monitoring part 20. In addition, the insulation monitoring result can be whether or not the insulation of the power line 50 is broken as distinguished by the insulation monitoring part 30.

Alternatively, the control part 100 can receive signal intensity change pattern information of a high-frequency current signal as an arc monitoring result of the arc monitoring part 20 or can receive the summed magnitude of frequency components related to the arc. Furthermore, by comparing the received signal intensity change pattern information with the pre-stored pattern information or comparing summed magnitude with a preset reference magnitude, it is possible to distinguish whether an arc has occurred. Furthermore, the control part 100 can receive insulation resistance as the insulation monitoring result from the insulation monitoring part 30 and compare the received insulation resistance with a reference value to distinguish the insulation state of the power line 50. Furthermore, depending on the judgment result, the semiconductor circuit breaker 110 can be driven.

The foregoing description of FIG. 5 has described an example in which two semiconductor switches 111-1, 111-2 are connected in series to form a bidirectional current flow. However, when the power line 50 is a unidirectional electric path in which a current flows in one direction, only one semiconductor switch can, of course, be provided.

In the foregoing description, the configuration of the insulation monitoring device 1 according to an embodiment of the present disclosure has been described.

In the following description, an operation process of the insulation monitoring device 1 according to the foregoing embodiment of the present disclosure will be described in more detail with reference to a plurality of flowcharts.

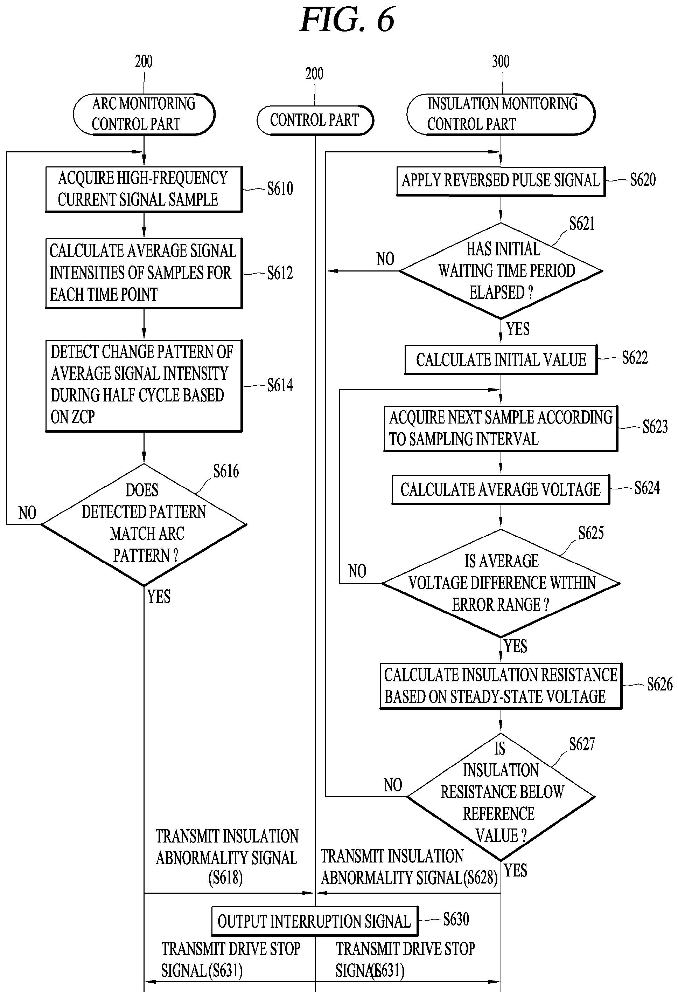

First, FIGS. 6 and 7 show different operation processes of the insulation monitoring system 1 that monitors, when a DC current flows in the power line 50, whether an arc occurs and whether insulation breakdown occurs from the power line. In this case, the insulation monitoring part 30 can further include a converter (not shown) that converts the AC current of the power line 50 into DC current or converts the DC current into AC current. Furthermore, through the converter, a pulse signal can be applied to a power line 50 through which an AC current flows, and the AC current detected from the power line 50 can be converted into a direct current through the converter.

First, FIG. 6 is a flowchart showing an operation process in which an arc monitoring part 20, an insulation monitoring part 30, and a circuit breaking part 10 are linked in an insulation monitoring system 1 according to an embodiment of the present disclosure.

Referring to FIG. 6, the arc monitoring control part 200 and the insulation monitoring control part 300 operate separately from each other to monitor an insulation state of the power line 50. Accordingly, a monitoring operation of the arc monitoring control part 200 and a monitoring operation of the insulation monitoring control part 300 can be performed simultaneously and in parallel.

First, looking at the operation process of the arc monitoring control part 200, the arc monitoring control part 200 can first acquire a sample of a high-frequency current signal (S610). Here, the samples of the high-frequency current signal can be samples detected at plurality of points in time based on the cycle of the AC current, based on the intensity of the high-frequency current signal from which the noise component has been filtered. For example, in the step S610, the arc monitoring control part 200 can acquire a preset number of high-frequency current signal intensity samples based on each time point, i.e., at each time point corresponding to a half cycle (point 1), a time point corresponding to a 1/8 cycle (point 2), a time point corresponding to a 1/4 cycle (point 3), and a time point corresponding to a 3/8 cycle (point 4), when the ZCP of the AC current is reached. Furthermore, the arc monitoring control part 200 can calculate the average signal intensities for each time point by averaging the acquired samples at each time point where sampling was performed (S612).

Furthermore, the arc monitoring control part 200 can detect the intensity change pattern of the high-frequency current signal based on the average signal intensities calculated for each time point (S614). In the step S614, the arc monitoring control part 200 can compare the average signal intensity of the first time point with the average signal intensity of the second time point, and compare the average signal intensity of the second time point with the average signal intensity of the third time point. Furthermore, the average signal intensity at the third time point can be compared with the average signal intensity at the fourth time point, and the average signal intensity at the fourth time point can be compared with the average signal intensity at the first time point of the next cycle. Furthermore, the average signal intensity at the first time point and the average signal intensity at the third time point can be compared. The result of this signal strength comparison can be the signal strength change pattern.

Then, the arc monitoring control part 200 can distinguish whether the detected signal intensity change pattern matches a preset pattern, i.e., a pattern corresponding to arc occurrence (hereinafter referred to as an arc pattern) (S616). For example, the arc pattern can be a pattern in which the signal intensity change pattern from the first time point to the fourth time point is an increase-decrease-increase-decrease pattern, that is, a pattern in which an increase is repeated and then a decrease is repeated, and the average signal intensity at the third time point has a greater value than the average signal intensity at the first time point.

As a result of the distinction in step S616, if the signal intensity change pattern detected in step S614 does not match the arc pattern, the arc monitoring control part 200 can proceed to step S610 again. Furthermore, the following process can be repeated to monitor whether an arc occurs.

However, if the signal intensity change pattern detected in step S614 matches the arc pattern as a result of the distinction in step S616, the arc monitoring control part 200 can determine that an arc has occurred in the power line 50. Then, the arc monitoring control part 200 can transmit an insulation abnormality signal to the control part 100 of the circuit breaking part 10 (S618). Then, the control part 100 of the circuit breaking part 10 can output an interruption signal to the semiconductor circuit breaker 110 to interrupt a connection to the power line 50 (S630). In this case, the interruption signal can include a circuit breaking switch control signal that drives the circuit breaking switch 150 to physically interrupt the power line 50.

Meanwhile, the control part 100 of the circuit breaking part 10 can output a drive stop signal to the insulation monitoring control part 300 when the load is disconnected from the power line 50 according to the interruption signal (S631). Then, the insulation monitoring control part 300 can discontinue an insulation monitoring operation. Likewise, the control part 100 of the circuit breaking part 10 can output a drive stop signal to the arc monitoring control part 200 to prevent an unnecessary arc monitoring operation from being performed.

Meanwhile, the step S616 can further include repeating the steps S610 to S614 a preset number of times or more. In this case, if a signal intensity change pattern matching the arc pattern is detected, the arc monitoring control part 200 can perform steps S610 to S614 again. Furthermore, when a signal intensity change pattern matching the arc pattern is detected by a preset number of times over a predetermined time period as a result of repeating the steps S610 to S614, it can be distinguished that an arc has occurred in the power line 50.

Meanwhile, separately from arc monitoring performed by the arc monitoring control part 200, the insulation monitoring control part 300 can perform insulation monitoring. Therefore, the insulation monitoring can be carried out while the arc monitoring is being performed.

First, the insulation monitoring control part 300 can apply a square wave pulse signal with a reversed polarity to the power line 50 (S620). Furthermore, in order to detect whether it is in a voltage stabilization state, whether a preset initial waiting time period has elapsed can be checked (S621). Furthermore, when the initial waiting time period has elapsed, a virtual circuit voltage detected from the signal measurement part 320 can be detected as an initial value (S622).

Furthermore, the insulation monitoring control part 300 can acquire a next sample according to a preset sampling interval (S623). Here, the acquired sample can be a virtual circuit voltage calculated after the sampling interval has elapsed. Furthermore, an average voltage between the acquired samples can be calculated (S624). In this case, an average voltage between the initial value and the next sample (first sample) can be calculated.

Meanwhile, when the average voltage is calculated, the insulation monitoring control part 300 can distinguish whether a voltage difference between the previously calculated average voltage and a currently calculated average voltage is within a preset error range (S625). In this case, since there is no previously calculated average voltage, the voltage difference between the average voltages can be out of a preset error range. Then, the insulation monitoring control part 300 can proceed to step S623 again to acquire a next sample (second sample) according to the sampling interval.

Then, in the step S624, an average voltage between the first sample and the second sample can be calculated. Then, the control part 100 can compare a currently calculated average voltage with an average voltage calculated in the previously calculated average voltage (an average voltage between the initial value and the first sample) to distinguish whether the voltage difference is within a preset normal range. Furthermore, when it is out of the normal range, it proceeds to step S623 again, and the process from step S623 to step S625 can be repeated.

Meanwhile, as a result of the distinction in step S625, when a voltage difference between the average voltages is within a preset error range, the insulation monitoring control part 300 can determine that the transient period due to the polarity reversal of the pulse signal has elapsed, and distinguish the currently detected voltage as a voltage in a stable state, that is, a normal voltage. Then, the insulation monitoring control part 300 can calculate the insulation resistance based on a normal voltage distinguished before the polarity reversal of the pulse signal and a currently distinguished normal voltage, that is, normal voltages distinguished when the polarity of the pulse signal is different (S626).

Furthermore, the insulation monitoring control part 300 can compare a magnitude of the calculated insulation resistance with a preset reference value (S627). As a result of the distinction in the step S627, when the insulation resistance calculated in the step S626 is above a preset reference value, the insulation monitoring control part 300 can determine that the insulation state of the power line 50 is good. Then, the insulation monitoring control part 300 can proceed to step S620 again to perform the following process again.

However, as a result of the distinction in the step S627, when the insulation resistance calculated in step S626 is below the preset reference value, the insulation monitoring control part 300 can determine that the insulation of the power line 50 has been destroyed. Then, the insulation monitoring control part 300 can transmit an insulation abnormality signal to the control part 100 of the circuit breaking part 10 (S628). Then, the control part 100 of the circuit breaking part 10 can output an interruption signal to the semiconductor circuit breaker 110 to interrupt a connection to the power line 50 (S630). In this case, the interruption signal can include a circuit breaking switch control signal that drives the circuit breaking switch 150 to physically interrupt the power line 50.

Meanwhile, the control part 100 of the circuit breaking part 10 can output a drive stop signal to the arc monitoring control part 200 when the load is disconnected from the power line 50 according to the interruption signal (S631). Then, the arc monitoring control part 200 can discontinue an arc monitoring operation. Likewise, the control part 100 of the circuit breaking part 10 can output a drive stop signal to the insulation monitoring control part 300 to prevent an unnecessary operation from being performed.

Meanwhile, in the foregoing description, it has been described, as an example, that a disconnection from the power line 50 is performed based on either an arc monitoring result of the arc monitoring control part 200 or an insulation monitoring result of the insulation monitoring control part 300, but the control part 100 of the circuit breaking part 10 can, of course, control the semiconductor circuit breaker 110 to perform the interruption operation based on both the arc monitoring result and the insulation monitoring result.

For example, when an insulation abnormality signal is received from the arc monitoring control part 200 (step S618), the control part 100 can postpone an interruption operation until an insulation monitoring result is received from the insulation monitoring control part 300. Furthermore, when an insulation abnormality signal is received from the insulation monitoring control part 300 (step S628), the interruption operation can also be performed. Alternatively, conversely, when an insulation abnormality signal is received from the insulation monitoring control part 300 (step S628), the interruption operation can be postponed until the insulation monitoring result received from the arc monitoring control part 200 is received, and when an insulation abnormality signal is also received from the arc monitoring control part 200 (step S618), the interruption operation can be performed. That is, the reliability of detecting insulation breakdown can be further improved by operating the arc monitoring result and the insulation monitoring result in a complementary manner.

Meanwhile, in the foregoing description, it has been described, as an example, that arc monitoring and insulation monitoring are performed separately, but on the contrary, arc monitoring can, of course, be performed to monitor the insulation state of the power line 50 while insulation monitoring is not performed.

As described above, in the case of insulation monitoring performed through insulation resistance in the insulation monitoring part 30, a virtual circuit voltage is required in a state where pulse voltages with different polarities are applied in order to calculate the insulation resistance. However, since the virtual circuit including the insulation resistance includes not only an insulation resistor but also an insulation capacitor, when the polarity of the pulse voltage is reversed, discharging and charging occur according to the insulation capacitor, thereby causing a transient period in which the voltage is unstable, unlike the applied pulse voltage. Therefore, the insulation monitoring control part 300 has a problem in that a time period occurs in which the insulation resistance is not calculated from a time at which the polarity of the pulse signal is reversed until the transition period elapses, and during that time period, the insulation state of the power line cannot be monitored.

Accordingly, the insulation monitoring system 1 according to an embodiment of the present disclosure can monitor an insulation state of the power line 50 by distinguishing whether an arc has occurred in the power line 50 based on a detection result of the arc monitoring part 20 during a time period in which the insulation monitoring part 30 is unable to calculate an insulation resistance, and monitor the insulation state of the power line 50 based on the insulation resistance when the insulation resistance is calculated.

FIG. 7 is a flowchart showing the operation process of a circuit breaking part 10 that performs insulation monitoring on a power line 50 in association with the arc monitoring part 20 and the insulation monitoring part 30 based on the voltage stabilization period according to the polarity reversal of the pulse signal in the insulation monitoring part 30 as an example of the insulation monitoring system 1 according to an embodiment of the present disclosure in such a case.

Meanwhile, according to the foregoing description, it has been mentioned that the arc monitoring part 20 does not directly distinguish whether an arc has occurred, but provides a signal intensity change pattern of the detected high-frequency current signal to the circuit breaking part 10 to allow the circuit breaking part 10 to determine whether an arc has occurred. In addition, it has been mentioned that the insulation monitoring part 30 does not directly distinguish the insulation state of the power line 50, but provides the calculated insulation resistance to the circuit breaking part 10 so as to allow the circuit breaking part 10 to determine the insulation state of the power line 50. Hereinafter, the circuit breaking part 10 of FIG. 7 will be described, as an example, in which the circuit breaking part 10 directly determines the insulation state of the power line 50 by receiving a signal intensity change pattern of the high-frequency current signal and the calculated insulation resistance as described above.

Referring to FIG. 7, the control part 100 of the circuit breaking part 10 can first detect whether the polarity of the pulse signal has been reversed in the insulation monitoring part 30 (S700).

For example, when the polarity reversal of the pulse signal is performed in the insulation monitoring part 30, the control part 100 can receive a notification signal (pulse polarity reversal signal) notifying the polarity reversal of the pulse signal from the insulation monitoring part 30.

To this end, the step S620 of FIG. 6 can further include transmitting, by the insulation monitoring control part 300, when the polarity of the pulse signal is reversed, the notification signal to the control part 100. In this case, the step S700 can be checking whether a pulse signal polarity reversal signal has been received from the insulation monitoring part 30.

As a result of the detection in the step S700, when the polarity reversal of the pulse signal has been performed, the control part 100 can check whether the insulation monitoring part 30 has entered a voltage stabilization phase (S702). Here, the voltage stabilization phase can be a phase in which the insulation resistance can be calculated after a transition period due to the polarity reversal of the pulse signal has elapsed. Therefore, the control part 100 can check whether the insulation monitoring part 30 has entered the voltage stabilization state based on whether insulation resistance has been received from the insulation monitoring part 30 after receiving a notification signal notifying the polarity reversal of the pulse signal (S702).

As a result of the check in step S702, when the insulation monitoring part 30 has not entered the voltage stabilization state, the control part 100 can receive signal intensity change pattern information of the high-frequency current signal detected from the arc monitoring part 20 (S704). For example, the signal intensity change pattern information can be detected for each half cycle of a current, for example, an AC current, flowing in the power line 50.

Then, the control part 100 can distinguish whether the received signal intensity change pattern matches a preset arc pattern (S706). Here, the information of the arc pattern can be stored in the memory 120 of the circuit breaking part 10.

As a result of the distinction in the step S706, when the signal intensity change pattern received from the arc monitoring part 20 matches the pre-stored arc pattern, the control part 100 can output an interruption signal for the semiconductor circuit breaker 110 to disconnect the load from the power line 50 even though the insulation resistance is not received from the insulation monitoring part 30 (S708). Furthermore, in order to prevent an unnecessary operation of the insulation monitoring part 30, a drive stop signal can be transmitted to the insulation monitoring part 30 (S710). Likewise, the control part 100 can transmit a drive stop signal to the arc monitoring part 20.

Meanwhile, as a result of the distinction in the step S706, when the signal intensity change pattern received from the arc monitoring part 20 does not match the pre-stored arc pattern, the control part 100 can proceed to step S702 again to check whether the insulation monitoring part 30 has entered the voltage stabilization state. Furthermore, as a result of the check in step S702, when the insulation monitoring part 30 does not enter the voltage stabilization state, the process from the step S704 to the step S706 can be performed again. That is, insulation monitoring can be continuously performed based on a detection result of the arc monitoring part 20 until the insulation resistance is received from the insulation monitoring part 30.

On the other hand, as a result of the check in step S702, when the insulation monitoring part 30 has entered the voltage stabilization state, that is, when the insulation resistance has been received from the insulation monitoring part 30, the control part 100 can compare the received insulation resistance with a reference value pre-stored in the memory 120 (S712). Furthermore, as a result of the comparison in step S712, when the insulation resistance is below the reference value, the semiconductor circuit breaker 110 can output an interruption signal to disconnect the load from the power line 50 (S714). Furthermore, in order to prevent an unnecessary operation of the arc monitoring part 20, a drive stop signal can be transmitted to the arc monitoring part 20 (S716). Likewise, the control part 100 can transmit a drive stop signal to the insulation monitoring part 30.

However, as a result of the comparison in step S712, when the insulation resistance is above the reference value, it can be determined that the insulation state of the power line 50 is good. Therefore, the circuit breaking part 10 can proceed to step S700 again to check whether a pulse signal polarity reversal notification signal received from the insulation monitoring part 30 has been received.

Then, when the insulation monitoring part 30 reverses the polarity of the pulse signal to calculate a next insulation resistance, the pulse signal polarity reversal notification signal is received by the circuit breaking part 10 again, and the process can proceed from step the S700 to the step S702 to monitor the insulation state of the power line 50 through arc monitoring before the insulation monitoring part 30 enters the voltage stabilization state according to the polarity reversal of the pulse signal, and through insulation monitoring after the insulation monitoring part 30 enters the voltage stabilization state.

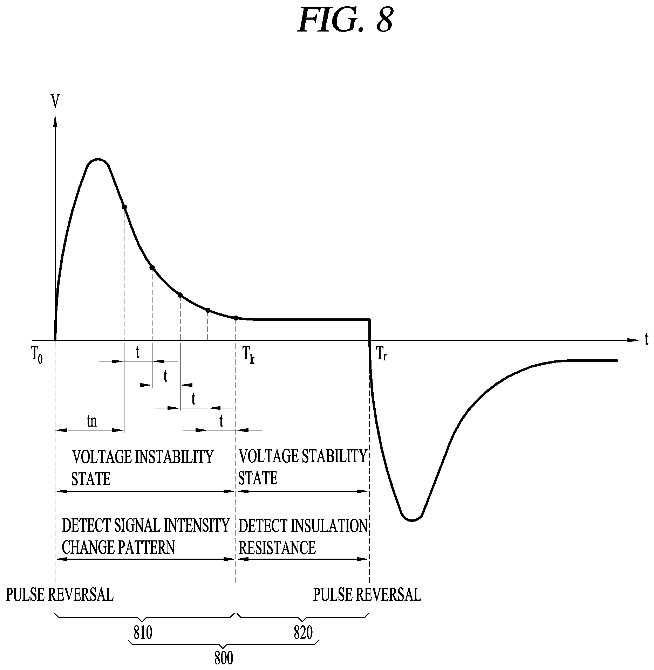

FIG. 8 is an exemplary diagram showing an example in which insulation monitoring is performed based on whether an arc occurs and an insulation resistance according to the voltage stabilization period according to the operation process of FIG. 7.

Referring to FIG. 8, FIG. 8 shows a detection time 800 from a time point at which the polarity of the pulse signal is reversed to a time point at which the polarity of the pulse signal is reversed again, which is an example of performing insulation monitoring according to an embodiment of the present disclosure.

First, when pulse reversal occurs, the insulation monitoring part 30 detects an initial value after an initial waiting time period tn has elapsed, and performs sampling at a preset time period t thereafter. Furthermore, an average voltage of the sampled virtual circuit voltage at each sampling interval t can be calculated, and a difference from the previously calculated average voltage can be calculated to distinguish whether a transition period has elapsed. Furthermore, an insulation resistance can be calculated based on a voltage detected after the transition period has elapsed.

Therefore, the insulation monitoring system 1 according to an embodiment of the present disclosure can monitor an insulation state of the power line 50 based on a signal intensity change pattern received from the arc monitoring part 20, as described in FIG. 7. Furthermore, when the voltage reaches a stabilized time point Tk, the insulation state of the power line 50 can be monitored based on the insulation resistance calculated by the insulation monitoring part 30. That is, during the detection period 800, the insulation monitoring of the power line 50 can be performed by using an intensity change pattern of the high-frequency current signal of the arc monitoring part 20 during a first period 810 in which the insulation state cannot be monitored by the insulation monitoring part 30 as the voltage becomes unstable due to the polarity reversal of the pulse signal, and by using an insulation resistance calculated by the insulation monitoring part 30 during a second period 820 in which the insulation resistance can be calculated by the insulation monitoring part 30 as the voltage is stabilized. An idle period in which insulation monitoring is not performed can be prevented from occurring.

Meanwhile, the foregoing FIGS. 6 to 8 show an example of a case where an AC current flows in the power line 50. However, the present disclosure can, of course, be applied not only to a power line through which an AC current flows, but also to a power line through which a DC current flows. In the case of a power line through which a DC current flows, the insulation monitoring part 30 can directly apply a pulse signal to the power line without a converter, and the signal measurement part 320 can directly measure a voltage of the power line.

However, in the case of the arc monitoring part 20, since the polarity of the DC current is not reversed, it can be difficult to detect an arc based on a cycle according to a ZCP. Accordingly, instead of detecting a change pattern in the intensity of a high-frequency current signal, the arc monitoring part 20 can perform a fast Fourier transform (FFT) on the detected high-frequency current signal, detect frequency components occurring during an occurrence of an arc from a result of the fast Fourier transform, and monitor an insulation state of a power line through which a DC current flows based on magnitudes of the detected frequency components.

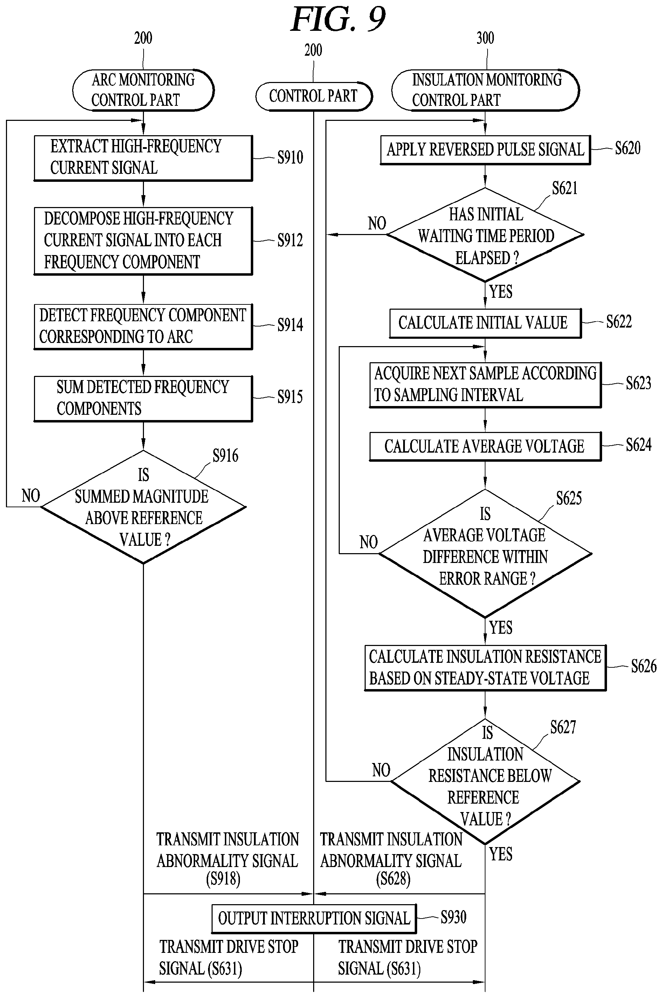

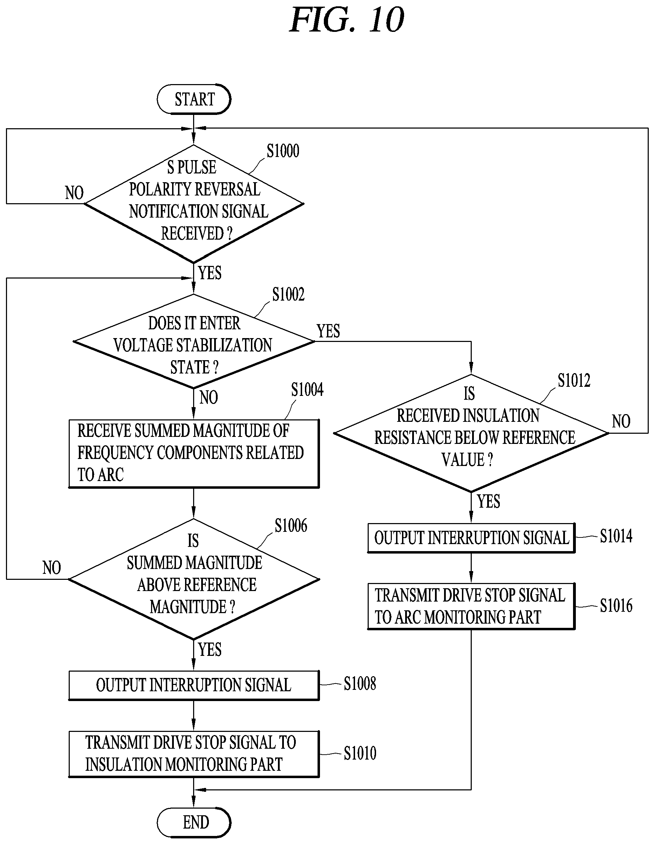

Hereinafter, FIGS. 9 and 10 show different operation processes of the insulation monitoring system 1 that monitors, when a DC current flows in the power line 50, whether an arc occurs and whether insulation breakdown occurs from the power line.

First, FIG. 9 is a flowchart showing an operation process in which the insulation monitoring system 1 according to an embodiment of the present disclosure monitors an insulation state, on a power line through which a DC current flow, in association with an arc monitoring part, an insulation monitoring part, and a circuit breaking part.

Referring to FIG. 9, the arc monitoring control part 200 and the insulation monitoring control part 300 operate separately from each other to monitor an insulation state of the power line 50. Accordingly, a monitoring operation of the arc monitoring control part 200 and a monitoring operation of the insulation monitoring control part 300 can be performed simultaneously and in parallel.

First, turning to an operation process of the arc monitoring control part 200, the arc monitoring control part 200 can acquire a high-frequency current signal with noise removed through the HFCT 210 and the filter part 220 (S910). Furthermore, the arc monitoring control part 200 can perform a fast Fourier transform on the acquired high-frequency current signal to decompose the high-frequency current signal into each frequency component (S912).

Furthermore, the arc monitoring control part 200 can detect frequency components corresponding to at least one preset frequency band from among the frequency components of the decomposed high-frequency current signal (S914). Here, the at least one preset frequency band can be a frequency band of a high-frequency current signal generated when an arc occurs in a DC electric path. That is, the preset at least one arc frequency band, which is a frequency band related to an occurrence of an arc, can be acquired through previously investigated statistical data or a plurality of arc occurrence experiments conducted in relation to the present disclosure. The information on a frequency band related to an occurrence of an arc can be stored in advance in the memory 120, and can be downloaded or updated through wireless or wired communication.

When frequency components included in at least one frequency band related to an occurrence of an arc pre-stored in the memory 270 are detected from among the frequency components of the high-frequency current signal detected by the fast Fourier transform in the step S914, the arc monitoring control part 200 can sum a magnitude (signal magnitude) of each of the detected frequency components (S915). Furthermore, the summed signal magnitude can be compared with a preset reference magnitude (S916).

Furthermore, when the signal magnitude summed in step S916 is below the preset reference magnitude, the arc monitoring control part 200 can determine that an arc has not occurred. Then, the process can proceed to step S910 again to perform steps subsequent thereto.

However, as a result of the distinction in the step S916, when the summed signal magnitude is below the preset reference magnitude, the arc monitoring control part 200 can determine that an arc has occurred in the power line 50. Then, the arc monitoring control part 200 can transmit an insulation abnormality signal to the control part 100 of the circuit breaking part 10 (S918). Then, the control part 100 of the circuit breaking part 10 can output an interruption signal to the semiconductor circuit breaker 110 to interrupt a connection to the power line 50 (S930). In this case, the interruption signal can include a circuit breaking switch control signal that drives the circuit breaking switch 150 to physically interrupt the power line 50.

Meanwhile, the control part 100 of the circuit breaking part 10 can output a drive stop signal to the insulation monitoring control part 300 when the load is disconnected from the power line 50 according to the interruption signal (S931). Then, the insulation monitoring control part 300 can discontinue an insulation monitoring operation. Likewise, the control part 100 of the circuit breaking part 10 can output a drive stop signal to the arc monitoring control part 200 to prevent an unnecessary arc monitoring operation from being performed.

Meanwhile, the step S916 can further include repeating the steps S910 to S914 a preset number of times or more. In this case, the arc monitoring control part 200 can perform the steps S910 to S914 again when a sum of frequency components related to an occurrence of an arc is above a preset reference magnitude. Furthermore, when a sum of frequency components having a value above a preset reference magnitude is calculated by a preset number of times over a predetermined time period as a result of repeating the steps S610 to S614, it can be distinguished that an arc has occurred in the power line 50.

Meanwhile, separately from arc monitoring performed by the arc monitoring control part 200, the insulation monitoring control part 300 can perform insulation monitoring. Therefore, the insulation monitoring can be carried out while the arc monitoring is being performed. In this case, an insulation monitoring process of the insulation monitoring part 30 can be the same as or similar to the operation process of the insulation monitoring part 30 as described above in FIG. 6. Accordingly, the operation process of the insulation monitoring part 30 will be omitted.

Meanwhile, it has been described that the insulation monitoring system 1 according to an embodiment of the present disclosure can monitor an insulation state of the power line 50 by distinguishing whether an arc has occurred in the power line 50 based on a detection result of the arc monitoring part 20 during a time period in which the insulation monitoring part 30 is unable to calculate an insulation resistance, and monitor the insulation state of the power line 50 based on the insulation resistance when the insulation resistance is calculated.

FIG. 10 is a flowchart showing the operation process of a circuit breaking part 10 that performs insulation monitoring on a power line 50 in association with the arc monitoring part 20 and the insulation monitoring part 30 based on the voltage stabilization period according to the polarity reversal of the pulse signal in the insulation monitoring part 30 as an example of the insulation monitoring system 1 according to an embodiment of the present disclosure in such a case. As shown above in FIG. 7, it will be described, as an example, that the circuit breaking part 10 of FIG. 10 also receives a sum of a magnitude of at least one frequency component related to an occurrence of an arc among the frequency components decomposed according to the fast Fourier transform and the calculated insulation resistance to directly determine an insulation state of the power line 50 by the circuit breaking part 10.

Referring to FIG. 10, the control part 100 of the circuit breaking part 10 can first detect whether the polarity of the pulse signal has been reversed in the insulation monitoring part 30 (S1000). To this end, the step S620 of FIG. 9 can further include transmitting, by the insulation monitoring control part 300, when the polarity of the pulse signal is reversed, the notification signal to the control part 100. In this case, the step S1000 can be checking whether a pulse signal polarity reversal signal has been received from the insulation monitoring part 30.

As a result of the detection in the step S1000, when the polarity reversal of the pulse signal has been performed, the control part 100 can check whether the insulation monitoring part 30 has entered a voltage stabilization phase (S1002). To this end, the control part 100 can check whether the insulation monitoring part 30 has entered the voltage stabilization state based on whether insulation resistance has been received from the insulation monitoring part 30 after receiving a notification signal notifying the polarity reversal of the pulse signal (S1002).

As a result of the check in the step S1002, when the insulation monitoring part 30 has not entered the voltage stabilization state, the control part 100 can receive a sum magnitude of at least one frequency component related to an occurrence of an arc among the frequency components decomposed according to the fast Fourier transform from the arc monitoring part 20 (S1004). Furthermore, it can be checked whether the sum magnitude is above a preset reference magnitude (S1006). Here, the information of the reference magnitude can be stored in the memory 120 of the circuit breaking part 10.

As a result of the distinction in the step S1006, when the sum magnitude received from the arc monitoring part 20 is above the reference magnitude, the control part 100 can output an interruption signal for the semiconductor circuit breaker 110 to disconnect the load from the power line 50 even though the insulation resistance is not received from the insulation monitoring part 30 (S1008). Furthermore, in order to prevent an unnecessary operation of the insulation monitoring part 30, a drive stop signal can be transmitted to the insulation monitoring part 30 (S1010). Likewise, the control part 100 can transmit a drive stop signal to the arc monitoring part 20.

Meanwhile, as a result of the distinction in the step S1006, when the sum magnitude received from the arc monitoring part 20 is below the reference magnitude, the control part 100 can proceed to step S1002 again to check whether the insulation monitoring part 30 has entered the voltage stabilization state. Furthermore, as a result of the check in step S1002, when the insulation monitoring part 30 does not enter the voltage stabilization state, the process from the step S1004 to the step S1006 can be performed again. That is, insulation monitoring can be continuously performed based on a detection result of the arc monitoring part 20 until the insulation resistance is received from the insulation monitoring part 30.

On the other hand, as a result of the check in step S1002, when the insulation monitoring part 30 has entered the voltage stabilization state, that is, when the insulation resistance has been received from the insulation monitoring part 30, the control part 100 can compare the received insulation resistance with a reference value pre-stored in the memory 120 (S1012). Furthermore, as a result of the comparison in step S1012, when the insulation resistance is below the reference value, the semiconductor circuit breaker 110 can output an interruption signal to disconnect the load from the power line 50 (S1014). Furthermore, in order to prevent an unnecessary operation of the arc monitoring part 20, a drive stop signal can be transmitted to the arc monitoring part 20 (S1016). Likewise, the control part 100 can transmit a drive stop signal to the insulation monitoring part 30.

However, as a result of the comparison in step S1012, when the insulation resistance is above the reference value, it can be determined that the insulation state of the power line 50 is good. Therefore, the circuit breaking part 10 can proceed to step S1000 again to check whether a pulse signal polarity reversal notification signal received from the insulation monitoring part 30 has been received.

Then, when the insulation monitoring part 30 reverses the polarity of the pulse signal to calculate a next insulation resistance, the pulse signal polarity reversal notification signal is received by the circuit breaking part 10 again, and the process can proceed from step the S1000 to the step S1002 to monitor the insulation state of the power line 50 through arc monitoring before the insulation monitoring part 30 enters the voltage stabilization state according to the polarity reversal of the pulse signal, and through insulation monitoring after the insulation monitoring part 30 enters the voltage stabilization state.

Meanwhile, in the foregoing description of the present disclosure, specific embodiments have been described, but various modifications can be made without departing from the scope of the present disclosure. In particular, in an embodiment of the present disclosure, an example of using a pattern of change in the intensity of a high-frequency current signal to distinguish whether an AC arc occurs, and using a sum of frequency components corresponding to a preset frequency band among frequency components of the high-frequency current signal to distinguish whether a DC arc occurs has been described, but an AC arc or a DC arc can, of course, be detected in other ways.

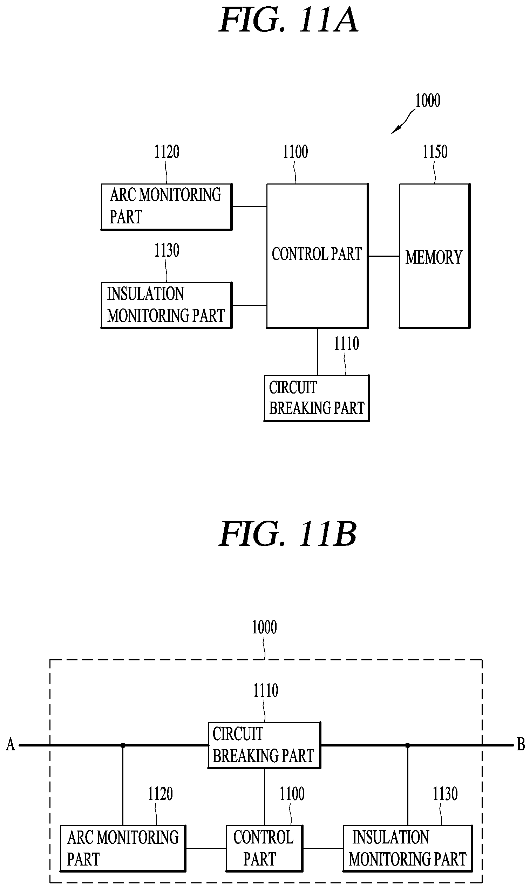

FIG. 11A is a block diagram showing a configuration of an insulation monitoring device 1000 according to another embodiment of the present disclosure. Furthermore, FIG. 11B is a conceptual diagram showing an example in which an arc monitoring part and an insulation monitoring part of the insulation monitoring device 1000 according to another embodiment of the present disclosure are connected to a power line.

First, referring to FIG. 11A, the insulation monitoring device 1000 according to another embodiment of the present disclosure can be configured to include a control part 1100, an arc monitoring part 1120, an insulation monitoring part 1130, and a circuit breaking part 1110 connected to the control part 1100, and a memory 1150.

More specifically, the circuit breaking part 1110 can be provided on a power line connecting between a power source and a load or a power line connecting between systems.

Referring to FIG. 11B, when a left side of the circuit breaking part 1110, that is, A, is connected to the power source, a right side of the circuit breaking part 1110, that is, B, can be connected to the load. Conversely, in FIG. 11B, when the right side B of the circuit breaking part 1110 is connected to the power source, the left side A of the circuit breaking part 1110 can be connected to the load. In this case, when one side is the power source and the other side is the load, a unidirectional current flow can be formed. Additionally, the A and B can be different power systems, such as different micro grids, in which case a bidirectional current flow can be formed not only from system A to system B, but also from system B to system A.

In order to connect or interrupt such a unidirectional or bidirectional current flow, the circuit breaking part 1110 can include a semiconductor circuit breaker including at least one semiconductor switch. Additionally, the circuit breaking part 1110 can be formed to be driven according to a control signal received from the control part 1100 to disconnect an electrical connection between the power source and the load whose insulation is damaged. In addition, the circuit breaking part 1110 can be configured to include not only the semiconductor circuit breaker that electrically disconnect a connection between the load and the power source, but also a circuit breaking switch that physically disconnect a connection between the load and the power source.

Furthermore, the arc monitoring part 1120 can detect information items related to an occurrence of an arc based on partial discharge that occurs during insulation breakdown. The arc monitoring part 1120 can detect information items related to whether an arc occurs in different ways when an AC current flows and when a DC current flows in the power line. For example, when the power line is a power line through which an AC current flows, a pattern of intensity change for a high-frequency current signal over a predetermined time period can be detected based on a high-frequency current signal detected from the power line. On the other hand, when the power line is a power line through which a DC current flows, information on the magnitudes of preset frequency components related to an occurrence of an arc among the frequency components of a high-frequency current signal detected from the power line can be detected. Furthermore, the detected information items can be transmitted to the control part 1100.

Then, the control part 1100 can distinguish whether an arc has occurred in the power line based on arc-related information provided from the arc monitoring part 1120, that is, information on the signal intensity change pattern or information on the magnitudes of preset frequency components.

For example, when the provided arc-related information is information on a signal intensity change pattern, the control part 1100 can compare the provided signal intensity change pattern with a preset signal intensity change pattern stored in the memory 1150, for example, a preset signal intensity change pattern of a high-frequency current signal generated when an arc occurs in a power line through which an AC current flows (hereinafter referred to as an arc signal intensity change pattern). Furthermore, as a result of the comparison, whether an arc occurs in the power line can be distinguished depending on whether the signal intensity change pattern provided from the arc monitoring part 1120 matches the arc signal intensity change pattern, or depending on whether the signal intensity change pattern provided from the arc monitoring part 1120 matches the arc signal intensity change pattern a specified number of times or more during a preset time period.

On the other hand, when the provided arc-related information is information on the magnitudes of preset frequency components, the control part 1100 can compare a value obtained by summing the magnitudes of the preset frequency components with a preset reference magnitude stored in the memory 1150, for example, a reference value obtained by summing the magnitudes of frequency components of a high-frequency current signal that occurs above a predetermined magnitude when an arc occurs in a power line through which a DC current flows. Furthermore, as a result of the comparison, whether an arc occurs in the power line can be distinguished based on whether the sum of the magnitudes of each frequency component provided from the arc monitoring part 1120 matches the reference magnitude stored in the memory 1150. Furthermore, when it is distinguished that an arc has occurred, it is determined that the insulation of the power line is damaged, and the circuit breaking part 1110 can be driven to disconnect an electrical connection between the power source and the load.

Meanwhile, the arc monitoring part 1120 can operate in different modes, for example, an AC arc detection mode and a DC arc detection mode, when an AC current flows or a DC current flows in the power line. Alternatively, the arc monitoring part 1120 can have different configurations when it is placed on a power line through which an AC current flows and when it is placed on a power line through which a DC current flows. That is, an arc monitoring part that detects an arc in a power line through which an AC current flows can have a different configuration from that of an arc monitoring part that detects an arc in a power line through which a DC current flows.

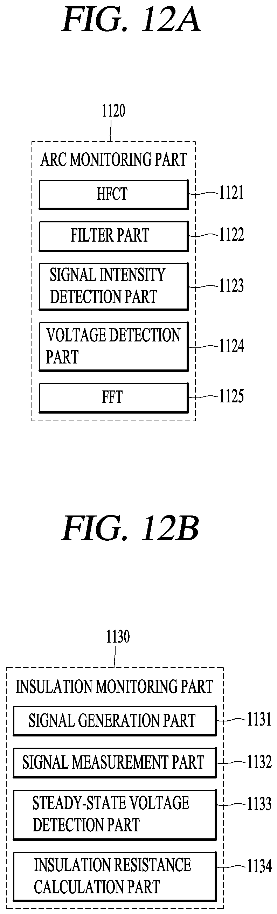

For such arc detection, the arc monitoring part 1120 can have various configurations, such as a high frequency current transformer (HFCT) for detecting a high-frequency current signal from a power line. The configuration of the arc monitoring part 1120 will be described in more detail with reference to FIG. 12A.

Meanwhile, the insulation monitoring part 1130 can calculate an insulation resistance in a power line through which a DC current flows or a power line through which an AC current flows. The insulation monitoring part 1130 can apply a square wave pulse signal having a preset voltage to a virtual circuit formed between the power line and the ground to calculate the insulation resistance, and calculate an insulation resistance Re based on a voltage distributed by a virtual resistance (insulation resistance Re) between the power line and the ground and an internal resistance Ri of the insulation monitoring part 1130 from the applied pulse signal. Furthermore, the calculated insulation resistance can be provided to the control part 1100.

Then, the control part 1100 can distinguish an insulation state of the power line based on the insulation resistance provided from the insulation monitoring part 1130. For example, when the provided insulation resistance is below a preset reference value, the control part 1100 can determine that the insulation of the power line has been destroyed (insulation damage). Then, the control part 1100 can drive the circuit breaking part 1110 to disconnect an electrical connection between the power source and the load.

Meanwhile, the control part 1100 can control each component connected thereto, and control an overall operation and function of the insulation monitoring device 1000. As described above, the control part 1100 can distinguish the insulation state of the power line based on the arc-related information provided from the arc monitoring part 1120 and the insulation resistance provided from the insulation monitoring part 1130. Furthermore, the control part 1100 can drive the circuit breaking part 1110 to disconnect the electrical connection between the power source and the load based on the distinguished insulation state of the power line.

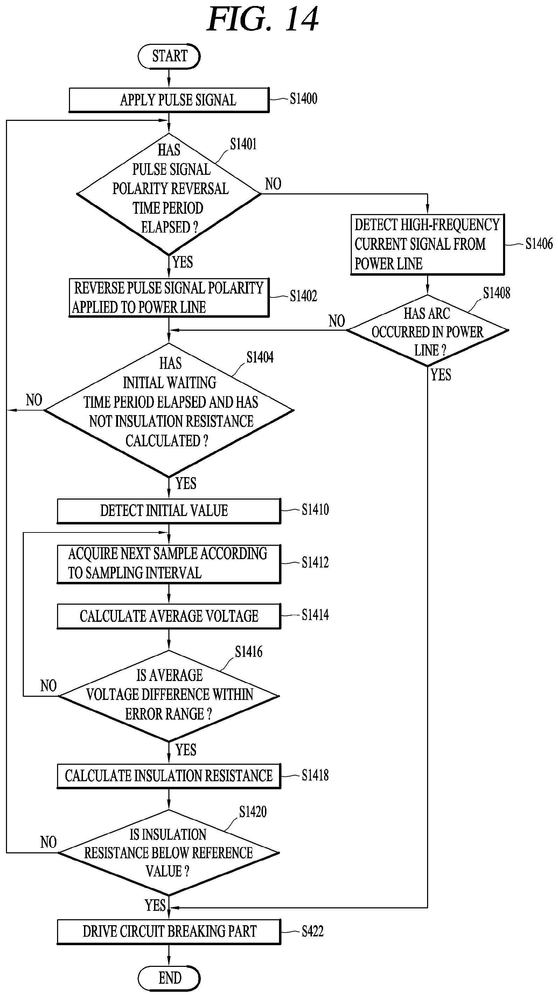

In addition, the control part 1100 can link an arc monitoring function of the arc monitoring part 1120 and an insulation monitoring function of the insulation monitoring part 1130 to each other. For example, the control part 1100 can control the arc monitoring part 1120 and the insulation monitoring part 1130 so as to allow the detection of an arc according to the monitoring function of the arc monitoring part 1120 and the calculation of an insulation resistance according to the monitoring function of the insulation monitoring part 1130 to be performed continuously in time series using an insulation monitoring state according to the calculation of the insulation resistance of the insulation monitoring part 1130 as a trigger condition. A control operation process of the arc monitoring part 1120 and the insulation monitoring part 1130 in the control part 1100 will be described in detail with reference to a plurality of flowcharts shown in FIG. 14 and therebelow.

Meanwhile, the memory 1150 stores data that supports various functions of the insulation monitoring device 1000. The memory 1150 can store data items and commands for the operation of multiple application programs or applications driven by the insulation monitoring device 1000 or each component constituting the insulation monitoring device 1000.

As an example, the memory 1150 can store data items for the arc monitoring function of the arc monitoring part 1120. For example, as data for the arc monitoring function, the memory 1150 can store information on a sampling time point for sampling a high-frequency current signal and a number of signal intensities to be sampled for detecting an arc occurring in a power line through which an AC current flows, that is, an AC arc, and information on an arc signal intensity change pattern that can distinguish whether an arc has occurred by comparing it with a signal intensity change pattern provided by the arc monitoring part 1120. In addition, when a signal intensity change pattern matching the arc signal intensity change pattern is detected, information on a reference time period and a reference number of times for comparing a number of times and a time period at which the signal intensity change pattern matching the arc signal intensity change pattern is detected can be stored.

Additionally, the memory 1150 can include information on at least one frequency band (arc frequency band) related to an occurrence of an arc to detect an arc occurring in a power line through which a DC current flows, that is, a DC arc. The arc frequency band can be a frequency band including a specific frequency component above a predetermined magnitude included in a high-frequency current signal generated when the DC arc occurs. In this case, the arc monitoring part 1120 can decompose the high-frequency current signal into each frequency component, and detect frequency components included in at least one arc frequency band stored in the memory 1150 from among the decomposed frequency components. Furthermore, the magnitudes of the detected frequency components can be transmitted to the control part 1100 as the arc-related information.

Here, the arc frequency band, which is a frequency band related to an occurrence of a DC arc, can be acquired through previously investigated statistical data or a plurality of arc occurrence experiments conducted in relation to the present disclosure. The arc frequency band can be stored in advance in the memory 1150 or can be downloaded or updated through wireless or wired communication.

Additionally, the memory 1150 can store various data items for the insulation monitoring function of the insulation monitoring part 1130. For example, the memory 1150 can include information on a voltage of a pulse signal applied to a power line by the insulation monitoring part 1130 and a time period for which the pulse signal maintains its characteristic polarity, i.e., the time for which the polarity of the pulse signal is reversed. That is, when the polarity of the pulse signal is reversed, the insulation monitoring part 1130 can maintain the polarity of the reversed pulse signal for the polarity reversal time period stored in the memory 1150, and when the polarity reversal time period expires, can reverse the polarity of the pulse signal again.

Additionally, the memory 1150 can store data items for voltage sampling to detect voltage stabilization according to the polarity reversal of the pulse signal in the insulation monitoring part 1130. For example, information items on an initial waiting time period for first sampling after the polarity of the pulse signal is reversed or a sampling interval can be stored in the memory 1150.

Meanwhile, the memory 1150 can store data input or output for the operation of the control part 1100. For example, the memory 1150 can store arc-related data provided from the arc monitoring part 1120 and an insulation resistance provided from the insulation monitoring part 1130. In addition, as reference data for comparing the arc-related data or insulation resistance, an insulation resistance reference value and a magnitude reference value of the arc signal intensity change pattern or arc frequency component can be stored. In addition, data for driving the circuit breaking part 1110 to control the circuit breaking part 1110, for example, data items for a threshold voltage of a semiconductor circuit breaker and data for controlling a circuit breaking switch, and the like, can be stored.

Hereinafter, referring to FIGS. 12A to 13, a configuration of each component of the insulation monitoring device 1000 according to an embodiment of the present disclosure will be described in more detail.

FIG. 12A is a block diagram showing components provided in the arc monitoring part 1120 according to an embodiment of the present disclosure.

Referring to FIG. 12A, the arc monitoring part 1120 can be configured to include a high frequency current transformer (HFCT) 1121 for detecting a high-frequency current signal, a filter part 1122 for frequency filtering, a signal intensity detection part (power detector) 1123 for detecting a signal intensity of the high-frequency current signal, and a voltage detection part 1124 for detecting a voltage change of a power line. In addition, the arc monitoring part 1120 can be configured to include a fast Fourier transformer (FFT) 1125 for decomposing the high-frequency current signal into each frequency component.

First, the HFCT 1121 can detect a high-frequency current signal in a power line. The high-frequency current signal, which is a signal in a high-frequency band generated by partial discharge caused by an arc, can also be referred to as a high-frequency noise signal.

Furthermore, the filter part 1122 can be a filter that filters a specific frequency using a frequency mask method. Here, the specific frequency can be a frequency corresponding to living noise, noise generated when driving a load, or electromagnetic compatibility (EMC) noise. The filter part 1122, which is a filter that filters a signal in at least one different frequency band that is designated in advance, can remove noise whose frequency band is known in advance, such as living noise, load driving noise, and EMC noise.

The signal intensity detection part 1123 can detect an intensity of the high-frequency current signal detected through the HFCT 1121. As an example, the signal intensity detection part 1123 can convert the high-frequency current signal detected by the HFCT 1121 into a voltage signal corresponding to its magnitude. Here, since the high-frequency current signal converted into the voltage signal can be an analog signal, the signal intensity detection part 1123 can further include an analog digital converter (ADC) for converting the high-frequency current signal in the analog form into a digital signal. Therefore, the high-frequency current signal converted into the voltage signal can be converted into a digital signal having different values depending on the signal intensity through the signal intensity detection part 1123.

In addition, the signal intensity detection part 1123 can further include an amplifier part (not shown) that can amplify an intensity of the converted high-frequency current signal into a signal at a level that can be identified by the control part 1100. The amplifier can be an inverting amplifier that inverts a phase of an input signal and amplifies the inverted signal phase as a voltage gain has a negative (-) value, or a non-inverting amplifier that amplifies only a magnitude of an input signal while maintaining the phase of the input signal as it is as a voltage gain has a positive (+) value.

Meanwhile, the voltage detection part 1124 can detect a voltage change in the power line. In this case, when a current flowing in the power line is a single-phase current, the current flowing in the power line can be a current in which a positive (+) voltage and a negative (-) voltage periodically change according to a cycle of the single-phase current. Therefore, a voltage change in which the positive (+) voltage and the negative (-) voltage periodically change is detected through the voltage detection part 1124, and based on the voltage change, the control part 1100 can detect a zero crossing point (ZCP) of the single-phase current. Here, the ZCP, which is a time point at which the polarity is reversed according to the periodic characteristics of an AC current, can refer to a time point at which the voltage becomes 0 according to a voltage change of the AC current.

Meanwhile, the control part 1100 can detect, when the power line is a power line through which an AC current flows, a time point at which a voltage changes from a positive (+) value to a negative (-) value, or a time point at which the voltage changes from a negative (-) value to a positive (+) value, based on a voltage change detected through the voltage detection part 1124, that is, zero crossing points.

Furthermore, the control part 1100 can detect a high-frequency current signal through the HFCT 1121. Furthermore, based on a detection result of the signal intensity detection part 1123, a change in the high-frequency current signal intensity over time can be detected. In this case, the control part 1100 can detect a change in the intensity of a high-frequency current signal corresponding to a half cycle of a current flowing in the power line based on the zero crossing points. Furthermore, whether an arc has occurred can be distinguished based on a pattern indicated by a change in the intensity of the high-frequency current signal during the detected half-cycle.

As an example, a voltage difference occurs between adjacent points where insulation is damaged or destroyed, that is, between two contacts of an electric path where the insulation is damaged or destroyed (hereinafter referred to as arc contacts), and a discharge phenomenon, that is, an arc, occurs due to the occurred voltage difference. However, since the single-phase current has a characteristic in which a voltage periodically increases and decreases according to the periodic characteristics of an AC current (e.g., zero crossing point), a voltage difference at the arc contacts also has a pattern in which it periodically increases and decreases. Accordingly, a high-frequency current signal generated by the arc can also have an increasing and decreasing pattern according to a periodic pattern (e.g., ZCP) of the AC current.

As an example, turning to a periodic characteristic when an AC arc occurs, the AC arc can proceed from a state in which no arc occurs (no arc state (no arcing) - no arc phase) as a voltage difference between the arc contacts is low, to a state in which an arc begins to occur at the arc contacts (arc strike state - arc strike phase) as the voltage difference between the arc contacts gradually increases, proceed from the arc strike state to a state in which the arc contacts are electrically connected through a discharge current (arc conduct state - arc conduct phase) as the voltage difference between the arc contacts reaches a maximum value, and proceed from the arc conduct state to a state in which the arc extinguishes (arc quenches state - arc quenches phase) as the voltage difference between the arc contacts gradually decreases. Furthermore, it can proceed from an arc quenches state to a no arc state again, thereby having a periodic characteristic of processing through the phases of no arc - arc strike - arc conduct - arc quenches.

In this case, an intensity of the high-frequency current signal in each of the no arc phase, arc strike phase, arc conduct phase, and arc quenches phase can be different from one another. For example, the arc strike phase and the arc quenches phase can be phases where no current is conducted despite having a large voltage, so the voltage difference between the arc contacts is large and thus the arc is the largest. That is, it can be a phase where the high-frequency current signal is generated most strongly.

Additionally, the arc conduct phase, which is a phase where a current is conducted between the arc contacts due to an arc discharge, can be a phase where the arc decreases even though the voltage is at its highest. Therefore, it can be a phase where the intensity of the high-frequency noise current signal decreases. In addition, the no arc phase, which is a phase where an arc does not occur or extinguishes due to a small voltage difference between the arc contacts, can be a phase where the intensity of the high-frequency current signal is the weakest because the arc is the least.

Therefore, in the arc strike phase and the arc quenches phase, a high-frequency current signal with a stronger intensity than that in the arc conduct phase and the no arc phase can be generated, and in the no arc phase, a high-frequency current signal with a weaker intensity than that in the arc conduct phase can be generated.

Accordingly, turning to a change in intensity of the high-frequency current signal due to the occurrence of an AC arc, when proceeding from the no arc phase (ZCP), the arc strike phase, the arc conduct phase, and the arc quenches phase to the no arc phase (ZCP) again, the intensity of the high-frequency current signal increases as it proceeds from the no arc phase to the arc strike phase, decreases as it proceeds again to the arc conduct phase, increases again as it proceeds from the arc conduct phase to the arc quenches phase, and decreases again as it proceeds to the no arc phase, having an increase - decrease - increase - decrease pattern, and can have a characteristic in which the intensity of the high-frequency current signal in the arc conduct phase is weaker than that in the no arc phase. Therefore, the control part 1100 can determine that an arc has occurred in the power line when a result of monitoring by the arc monitoring part 1120 for a power line through which an AC current flows (an intensity change pattern and characteristic of the high-frequency current signal) is detected at least once over a predetermined time period.

Meanwhile, the arc monitoring part 1120 can detect an arc according to an intensity change pattern of the high-frequency current signal according to an interval between ZCPs as described above in the case of a power line through which an AC current flows, but in the case of a DC current flowing without a change in polarity, it can be difficult to detect an arc using the foregoing method. Accordingly, the arc monitoring part 1120 can be configured to include an FFT 1125 that analyzes a frequency component of a high-frequency current signal detected by the HFCT 1121 to detect an arc in a power line through which a DC current flows, that is, a DC arc.

When the power line is a power line through which a DC current flows, the FFT 1125 can perform a fast Fourier transform on the high-frequency current signal detected from the power line. Therefore, the high-frequency current signal generated when a DC arc occurs can be decomposed into each frequency component.

Then, the arc monitoring part 1120 can detect at least one frequency component (arc frequency component) related to an occurrence of a DC arc from among the decomposed frequency components based on at least one arc frequency band stored in the memory 1150. Furthermore, the magnitudes of the detected arc frequency components can be transmitted to the control part 1100. Alternatively, the control part 1100 can acquire the magnitudes of at least one or more frequency components based on the arc frequency band from each frequency component acquired by decomposing the high-frequency current signal as a result of the fast Fourier transform of the arc monitoring part 1120. Then, the control part 1100 can determine whether an arc (DC arc) has occurred in the power line based on the acquired magnitudes of the frequency components.

Meanwhile, in the foregoing description, it has been described as an example that the arc monitoring part 1120 includes all components including the FFT 1125 to detect both an AC arc that occurs when an AC current flows and a DC arc that occurs when a DC current flows in a power line, but it can, of course, have only some components for detecting an AC arc or a DC arc.

For example, when the arc monitoring part 1120 only monitors an AC arc (when an AC current flows in the power line), the arc monitoring part 1120 can include only an HFCT 1121, a filter part 1122, a signal intensity detection part 1123, and a voltage detection part 1124. On the other hand, when the arc monitoring part 1120 only monitors a DC arc (when a DC current flows in the power line), the arc monitoring part 1120 can be configured to include only the HFCT 1121 and the FFT 1125. That is, depending on a current flowing in the power line, the arc monitoring part 1120 can have different components and can distinguish whether an arc has occurred in different ways.

FIG. 12B is a block diagram showing components provided in the insulation monitoring part 1130 according to an embodiment of the present disclosure.

The insulation monitoring part 1130 of the insulation monitoring device 1000 according to an embodiment of the present disclosure can include a coupler resistor connected to a power line, a signal generation part 1131 that applies a square wave pulse signal to the power line through the coupler resistor, a signal measurement part 1132 including a virtual insulation resistance formed between the power line and the ground, and a detection resistor connected to the ground, a steady-state voltage detection part 1133 that receives a voltage measured by the signal measurement part, calculates an average voltage according to a pulse signal applied to the power line during a preset sampling section, and calculates a steady-state voltage after a voltage instability state due to the polarity reversal of the pulse signal has elapsed based on an error with the previously calculated average voltage, and an insulation resistance calculation part 1134 that calculates a magnitude of an insulation resistance based on the calculated steady-state voltage and a steady-state voltage calculated for a pulse signal with a different polarity, which is calculated before the polarity reversal of the pulse signal.

First, the signal generation part 1131 can generate a pulse signal having a constant positive (+) voltage or a constant negative (-) voltage for a preset time period under the control of the control part 1100. Furthermore, the generated pulse signal can be applied to the power line. Accordingly, a pulse signal in which positive and negative voltages alternate based on the preset time period can be applied to the power line under the control of the insulation monitoring control part 300.

Meanwhile, the power line and the ground can be connected to each other through a virtual circuit. Furthermore, a virtual insulation resistance can be formed between the power line and the ground. Additionally, a virtual capacitor can be further formed between the power line and the ground. The virtual capacitor can form an insulation impedance between the power line and the ground together with the insulation resistance.

Therefore, a pulse signal applied to a power line can be input to a signal measurement part 1132 through the virtual circuit formed between the power line and the ground, and through the insulation resistor and the capacitor. Then, the signal measurement part 1132 can detect a voltage of the virtual circuit in which the insulation impedance is reflected based on a voltage across the two terminals of the detection resistor. Meanwhile, the detection result of the signal measurement part 1132 can be amplified to an identifiable magnitude and converted into a digital value. To this end, the signal measurement part 1132 can be configured to include an amplifier (Amp) (not shown) and an analog digital converter (ADC) (not shown) that converts a voltage measured by the signal measurement part 1132 into a digital value.

Meanwhile, the insulation resistance can be calculated based on a virtual circuit voltage for pulse signals with different polarities. However, when the voltage changes from a positive voltage to a negative voltage or the polarity of the pulse signal changes from a negative voltage to a positive voltage, discharging and charging by the insulating capacitor can be induced. Accordingly, a transient period occurs in which the voltage increases several times more than the applied pulse voltage, and the voltage of the virtual circuit becomes unstable. In this case, when a voltage of the virtual circuit is unstable, an accurate insulation resistance is not calculated.

Therefore, the control part 1100 can detect a change in the voltage of the virtual circuit measured by the signal measurement part 1132 according to a preset sampling interval, and control the insulation monitoring part 1130 to determine whether the virtual circuit voltage is stabilized based on the detected voltage change.

To this end, the control part 1100 can control the signal measurement part 1132 to detect the voltage of the virtual circuit at each preset sampling interval. Furthermore, the steady-state voltage detection part 1133 can calculate an average voltage of the virtual circuit measured by the signal measurement part 1132 during a sampling section according to the sampling interval under the control of the control part 1100. Furthermore, when a difference between the calculated average voltage and that during the previous sampling section is below a preset error value, it can be distinguished that the voltage of the virtual circuit is stabilized.

Meanwhile, when a steady-state voltage is calculated by the steady-state voltage detection part 1133, the insulation resistance calculation part 1134 can calculate a magnitude of the insulation resistance based on a stabilized virtual circuit voltage (first steady-state voltage) calculated before the polarity of the pulse signal is reversed and a stabilized virtual circuit voltage (second steady-state voltage) calculated after the polarity of the pulse signal is reversed. Furthermore, the calculated insulation resistance can be transmitted to the control part 1100.

Then, the control part 1100 can determine an insulation state of the power line based on the received magnitude of the insulation resistance. That is, when the insulation resistance is below a preset reference value, it can be determined that the power line is in a state of insulation damage to drive the circuit breaking part 1110. Then, an electrical connection between the power source and the load can be disconnected.

However, when the received magnitude of the insulation resistance is above the reference value, the control part 1100 can determine that the insulation state of the power line is good. Then, the control part 1100 can control the signal generation part 1131 again to reverse the polarity of the pulse signal, and control the insulation monitoring part 1130 to calculate the insulation resistance.

Meanwhile, the insulation monitoring part 1130 can also distinguish the insulation state of the power line for not only a DC current but also an AC current. For example, in the case of an AC current, the insulation monitoring part can further include a converter (not shown) for converting the AC current of the power line into a DC current. In this case, a pulse signal can be applied to a power line through which an AC current flows through the converter, and an AC current detected from the power line can be converted into a DC current through the converter. Furthermore, the signal measurement part 1132 can detect a voltage of the converted DC current. Accordingly, the insulation monitoring part 1130 can monitor an insulation state of not only a power line through which a DC current flows but also a power line through which an AC current flows.

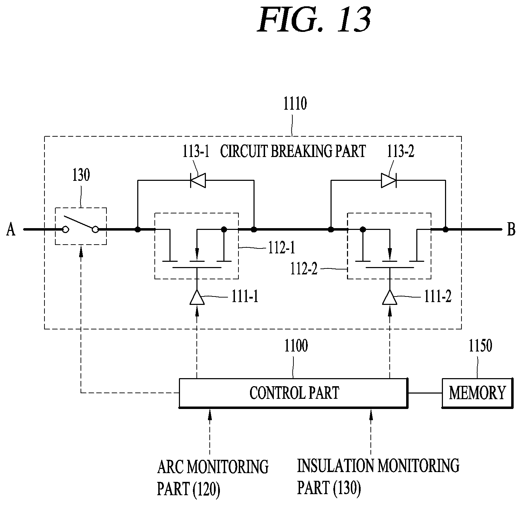

FIG. 13 is a block diagram showing a detailed configuration of a circuit breaking part of an insulation monitoring device according to an embodiment of the present disclosure.

As shown in FIG. 13, the circuit breaking part 1110 can include a semiconductor circuit breaker consisting of a plurality of semiconductor switches 112-1, 112-2 connected in series to connect a bidirectional current flow. Here, the semiconductor circuit breaker can be a solid state circuit breaker (SSCB) capable of high-speed current interruption.

In this way, a plurality of semiconductor switches can be connected in series to one another, each of which has a source terminal and a drain terminal connected to different ends of the semiconductor circuit breaker, the circuit breaking part 1110 can be formed to control the flow of a bidirectional current flowing from side B to side A as well as flowing from side A to side B.

Meanwhile, the source and drain terminals of each of the first semiconductor switch 112-1 and the second semiconductor switch 112-2 can be connected through the gate terminal of each semiconductor switch. Each gate terminal is connected to each gate driver 111-1, 111-2, and each source terminal and drain terminal can be electrically connected based on a voltage applied to the gate terminal from the gate driver, that is, a gate voltage. In this case, when the gate voltage is above a preset threshold voltage, the source terminal and the drain terminal can be electrically connected to each other. On the other hand, when the gate voltage is below the threshold voltage or no gate voltage is applied, the source terminal and the drain terminal can not be electrically connected to each other. That is, an electrical connection between side A and side B can be disconnected.

Meanwhile, the control part 1100 can control the gate driver 111-1, 111-2 of each semiconductor switch to allow an electrical connection between the side A and the side B side to be disconnected by adjusting a gate voltage applied to the gate terminal of each semiconductor switch 112-1, 112-2.

Here, the control part 1100 can control the circuit breaking part 1110 based on an arc monitoring result (e.g., signal intensity change pattern or arc frequency components) received from the arc monitoring part 1120 or an insulation state monitoring result (e.g., insulation resistance) received from the insulation monitoring part 1130.

The foregoing description of FIG. 13 has described an example in which two semiconductor switches 111-1, 111-2 are connected in series to form a bidirectional current flow. However, when the power line is a unidirectional electric path in which a current flows in one direction, only one semiconductor switch can, of course, be provided.

In the foregoing description, the configuration of the insulation monitoring device 1000 according to an embodiment of the present disclosure has been described.

In the following description, an operation process of the insulation monitoring device 1000 according to the foregoing embodiment of the present disclosure will be described in more detail with reference to a plurality of flowcharts.

First, FIG. 14 is a flowchart showing an operation process of an insulation monitoring device according to an embodiment of the present disclosure.

Referring to FIG. 14, the control part 1100 of the insulation monitoring device 1000 according to an embodiment of the present disclosure can apply a preset magnitude of signal having a positive or negative voltage to the power line when the drive of the insulation monitoring device 1000 starts (S1400). Furthermore, the control part 1100 can check whether a preset polarity reversal time period has elapsed (S1401). In this case, when the polarity reversal time period has elapsed, the control part 1100 can apply a voltage having the same magnitude but opposite polarity to the power line. That is, a pulse signal whose voltage polarity is reversed based on the polarity reversal time period can be applied to the power line. Furthermore, when the voltage polarity of the pulse signal is reversed, a time period elapsed from a time point at which the pulse signal is applied can be initialized.

When a result of the check in the step S1401 does not reach the preset polarity reversal time period, the control part 1100 can control the arc monitoring part 1120 to detect a high-frequency current signal from the power line (S1406). Furthermore, based on the arc-related information provided from the arc monitoring part 1120 based on the detected high-frequency current signal, it can be distinguished whether an arc has occurred in the power line (S1408).

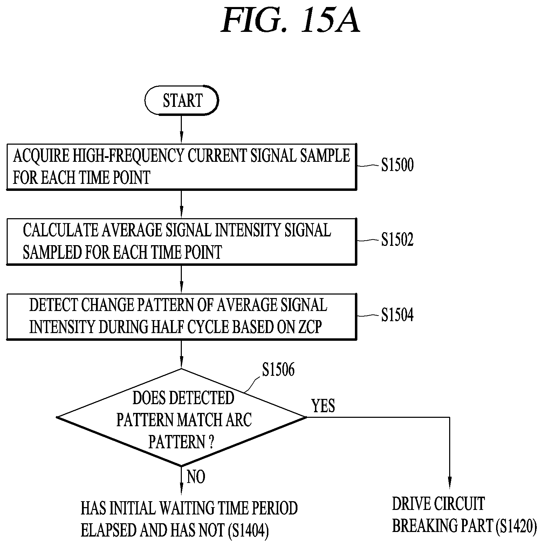

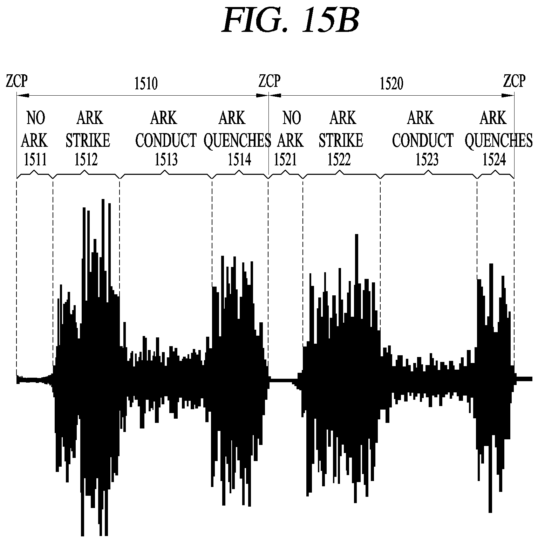

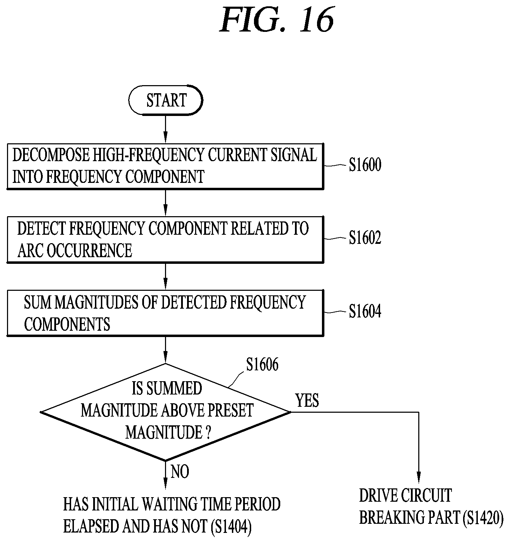

The process of detecting whether an arc has occurred in the step S1408 can differ depending on whether the power line is a power line through which an AC current flows or a power line through which a DC current flows. Hereinafter, an operation process of the control part 1100 that detects an AC arc that occurs when the power line is a power line through which an AC current flows will be described with reference to FIGS. 15A and 15B, and an operation process of the control part 1100 that detects a DC arc that occurs when the power line is a power line through which a DC current flows will be described in detail with reference to FIG. 16.

Meanwhile, when it is determined that an arc has occurred in the power line as a result of the distinction in the step S1408, the control part 1100 can drive the circuit breaking part 1110 to disconnect the load from the power line (S1422). In this case, the control part 1100 can control each gate driver 111-1, 111-2 to apply a gate voltage below a preset threshold voltage. Alternatively, each of the gate drivers 111-1, 111-2 can be controlled so as not to allow the gate voltage to be applied. Furthermore, the circuit breaking switch 130 can be driven to physically disconnect between the power line and the load.

On the other hand, in the step S1408, as a result of distinguishing whether an arc has occurred based on the arc-related information received from the arc monitoring part 1120, when the arc has not occurred, the control part 1100 can check whether an initial sampling time point for starting sampling has been reached to detect a time point at which the voltage is stabilized after a pulse signal having a specific polarity is applied. To this end, the control part 1100 can check whether a time period elapsed from a time point at which the voltage polarity of the pulse signal is reversed is above a preset initial waiting time period (hereinafter, whether an initial waiting time period has elapsed) and whether an insulation resistance corresponding to the voltage polarity of the pulse signal currently applied to the power line has been calculated (S1404).

Here, the initial waiting time period is to start sampling to detect a time point at which the voltage is stabilized after the polarity of the pulse signal is switched as described above, and can be a time period until the initial sampling time point is reached after the pulse signal having the specific polarity is applied. Therefore, the initial waiting time period, which is a time period between when the polarity of the pulse signal is reversed and when the polarity is reversed again, can be a time period shorter than the polarity reversal time period. Therefore, the polarity reversal time period of the pulse signal can expire after the initial waiting time period has elapsed from a time point at which a pulse signal having a specific polarity is applied.

In the step S1404, the control part 1100 can check whether the initial waiting time period has elapsed since a time point at which a pulse signal having a specific polarity is applied and whether the insulation resistance corresponding to the voltage polarity of the pulse signal currently applied to the power line has been calculated. Furthermore, when any of the conditions is not satisfied, the control part 1100 can proceed to step S1401 again to check whether the polarity reversal time period has elapsed for the polarity of the pulse signal.

Furthermore, when the polarity reversal time period has not elapsed as a result of the check in step S1401, the control part 1100 can proceed again to steps S1406 and S1408. Therefore, the control part 1100 can repeatedly perform a process of distinguishing whether an arc has occurred based on a high-frequency current signal detected from the power line when as a result of the check in the step S1404, the initial waiting time period has not been reached from a time point at which a pulse signal having a specific polarity is applied, or when the insulation resistance corresponding to the voltage polarity of the pulse signal currently applied to the power line has been calculated even after the initial waiting time period has elapsed.

Meanwhile, as a result of the check in the step S1404, when the initial waiting time period has been reached and the insulation resistance corresponding to the voltage polarity of the pulse signal currently applied to the power line has not been calculated, the control part 1100 can control the insulation monitoring part 1130 to detect a virtual circuit voltage between the power line and the ground detected by the signal measurement part 320 as an initial value at a time point at which the initial waiting time period has elapsed (S1410).

Furthermore, the control part 1100 can acquire a next sample according to a preset sampling interval (S1412). Here, the acquired sample can be the virtual circuit voltage calculated after the sampling interval has elapsed. Furthermore, an average voltage between the acquired samples can be calculated (S1414). In this case, an average voltage between the initial value and the next sample (first sample) can be calculated.

Meanwhile, when the average voltage is calculated, the control part 1100 can distinguish whether a voltage difference between an average voltage calculated in the previous sampling section and an average voltage calculated in the current sampling section is within a preset error range (S1416). When there is no average voltage calculated in the previous sampling section, a voltage difference between the average voltages can be out of the error range. Therefore, the control part 1100 can proceed to step S1412 again to acquire a next sample (second sample) according to the sampling interval.

Then, in the step S1414, an average voltage between the first sample and the second sample can be calculated. Then, the control part 1100 can compare a currently calculated average voltage with an average voltage calculated in the previous sampling section (an average voltage between the initial value and the first sample) to distinguish whether the voltage difference is within the error range. Furthermore, when it is out of the error range, it proceeds to step S1412 again, and the process from step S1412 to step S1414 can be repeated.

Meanwhile, as a result of the distinction in step S1416, when the voltage difference between the average voltages calculated in each sampling section is within the error range the control part 1100 can determine that a voltage instability phenomenon caused by the polarity reversal of the pulse signal has been resolved, and distinguish the currently detected voltage as a voltage in a stable state, that is, a normal voltage. Then, the control part 1100 can calculate the insulation resistance based on a normal voltage distinguished before the polarity of the pulse signal is reversed and a currently distinguished normal voltage, that is, normal voltages distinguished when the polarity of the pulse signal is different (S1418).

Furthermore, the control part 1100 can compare a magnitude of the calculated insulation resistance with a preset reference value (S1420). As a result of the distinction in the step S1420, when the calculated insulation resistance is below a preset reference value, the control part 1100 can determine that the power line is in a state of insulation damage. Then, the control part 1100 can control the circuit breaking part 1110 to interrupt a connection to the power line (S1422). In this case, the step S1422 can include driving a circuit breaking switch 150 to physically disconnect the load from the power line.

On the other hand, as a result of the distinction in the step S1420 when the calculated insulation resistance is above a preset reference value, the control part 1100 can determine that the insulation state of the power line is good. Then, the control part 1100 can proceed to step S1401 again. Therefore, whether the polarity reversal time period to reverse the polarity of the pulse signal has expired. Furthermore, when the polarity reversal time period has not yet expired, the control part 1100 proceeds to step S1406 again to control the arc monitoring part 1120 to detect a high-frequency current signal from the power line, and distinguishes whether an arc has occurred through step S1408.

Furthermore, as a result of the distinction in step S1408, when an arc has occurred, the control part 1100 can proceed to step S1422 to drive the circuit breaking part 1110. However, as a result of the distinction in step S1408, when no arc has occurred, the control part 1100 can proceed to step S1404 again to check whether the initial waiting time period has elapsed and whether the insulation resistance has not been calculated. In this case, since the insulation resistance corresponding to the voltage polarity of the pulse signal currently applied to the power line is calculated, both conditions in the step S1404 can not be satisfied. Accordingly, the control part 1100 can proceed to step S1401 again to check whether the polarity reversal time period of the pulse signal has expired.

Furthermore, when the polarity reversal time period has expired as a result of the check in step S1401, the control part 1100 can reverse the polarity of the signal applied to the power line (S1402). Accordingly, a signal having a reversed polarity can be applied to the power line, and a pulse signal whose polarity is reversed at a cycle of the polarity reversal time period can be applied to the power line.

Meanwhile, when the polarity of the pulse signal is reversed in step S1402, the control part 1100 can proceed to step S1404 to check whether the initial waiting time period has elapsed since a pulse signal having a specific polarity was applied and whether the insulation resistance corresponding to the voltage polarity of the pulse signal currently applied to the power line, that is, the insulation resistance corresponding to the pulse signal whose polarity of the voltage signal is reversed, has been calculated. Furthermore, when both conditions of step S1404 are not satisfied, the process can proceed to steps S1406 and S1408 again to distinguish whether an arc has occurred based on a high-frequency current signal detected from the power line before reaching a preset initial waiting time period.

Meanwhile, FIG. 15A and FIG. 15B is a more detailed description of an operation process of detecting whether an arc has occurred in a power line through the arc monitoring part 1120 in the step S1408 when an AC current flows in the power line during the operation process of the insulation monitoring device described in FIG. 14.

First, referring to FIG. 15A, the control part 1100 can control the arc monitoring part 1120 to acquire samples from a high-frequency current signal detected from a power line (S1500).

For example, the control part 1100 can determine sampling time points to sample a preset number of samples from a ZCP to a ZCP, that is, during a time period corresponding to a half cycle of the AC current flowing in the power line.

As described above, when the insulation of the power line is broken, a voltage difference between two contacts (hereinafter referred to as arc contacts) of an electric path increases or decreases over time due to the characteristics of an AC current, in which the voltage increases or decreases over time, and thus has a pattern in which the intensity of the arc also increases or decreases.

Referring to FIG. 15B, turning to a periodic characteristic in which an arc occurs and extinguishes, the voltage approaches 0 before and after the ZCP of the AC current, and thus a voltage difference between the arc contacts decreases. Accordingly, it can enter the no arc phase 1511, 1521 where no arc occurs. However, as the voltage gradually increases past the ZCP, the voltage difference between the arc contacts increases, and accordingly, it can enter the arc strike phase 1512, 1522 in which the arc increases. Furthermore, when the voltage difference between the arc contacts reaches a 1/4 cycle having a maximum value, the arc can enter the arc conduct phase 1513, 1523 in which the arc is reduced because some current is conducted between the arc contacts through a current discharged from the arc contacts. Furthermore, as the voltage drops after the maximum value, the arc discharge also decreases, so an electrical connection between the arc contacts is broken again, and the arc can enter the arc quenches phase 1514, 1524 where the arc increases again. Furthermore, after the arc quenches phase 1514, 1524 phase, it can enter the no arc phase 1511, 1521 again.

That is, in the case of an AC arc, the intensity of the arc has a relatively changing pattern depending on a periodic characteristic of the AC current flowing in the power line. Accordingly, the intensity of the high-frequency current signal can also have a pattern in which the signal intensity changes similarly to a no arc phase - arc strike phase - arc conduct phase - arc quenches phase - no arc phase between a ZCP and a ZCP of the AC current, that is, during a half cycle of the AC current.

In order to detect such a signal intensity change pattern, the control part 1100 can acquire a preset number of samples at each time point corresponding to each phase of the AC arc. In this case, the control part 1100 can determine a time point corresponding to a ZCP, which is a time point at which the voltage is the lowest, and a time point corresponding to a 1/4 cycle, which is a time point at which the voltage is the highest, as first and third time points for performing sampling corresponding to the no arc phase and the arc conduct phase, respectively. Furthermore, the control part 1100 can determine a time point between the first and third time points and a time point corresponding to a next ZCP after the third time point can be determined as a second time point and a fourth time point for performing sampling corresponding to the arc strike phase and the arc quenches phase, respectively.

For example, the second time point can be a time point corresponding to a 1/8 cycle of the AC current, and the fourth time point can be a time point corresponding to a 3/8 cycle of the AC current. In this case, the first to fourth time points can be time points corresponding to a ZCP, a 1/8 cycle, a 2/8 (1/4) cycle, and a 3/8 cycle, respectively. Here, the foregoing sampling time points are merely examples to help the description of the present disclosure, and the present disclosure is not limited thereto.

Hereinafter, a preset number of high-frequency current signals sampled based on the first time point are referred to as first samples, and a preset number of high-frequency current signals sampled based on the second time point are referred to as second samples. Likewise, the high-frequency current signals sampled at the third and fourth time points, respectively, are referred to as third and fourth samples. Here, the first samples can be samples acquired in the no arc phase 1511, 1521, and the second samples can be samples acquired in the arc strike phase 1512, 1522. Additionally, the third samples can be samples 1513, 1523 acquired in the arc conduct phase, and the fourth samples can be samples acquired in the arc quenches phase 1514, 1524.

When sampling for each sampling time point is completed in the step S1500, the control part 1100 can calculate a signal intensity average of the high-frequency current signals sampled for each time point (S1502). Accordingly, a signal intensity average (first signal intensity average) for the first samples acquired in the no arc phase 1511, 1521 can be calculated. Furthermore, a signal intensity average (second signal intensity average) for the second samples acquired in the arc strike phase 1512, 1522 can be calculated. Additionally, signal intensity averages (third and fourth signal intensity averages) for the third and fourth samples acquired in the arc conduct phase 1513, 1523 and the arc quenches phase 1514, 1524 can be calculated.

Then, the control part 1100 can detect an intensity change pattern of a high-frequency current signal from the signal intensity averages in the each arc phase (S1504). For example, the control part 1100 can detect a change in the signal intensity average when the cycle of the AC current proceeds from a ZCP time point to a 1/8 cycle time point by comparing the first signal intensity average with the second signal intensity average. Furthermore, the control part 1100 can detect a change in the signal intensity average when the cycle of the AC current proceeds from a 1/8 cycle time point to a 2/8 cycle (1/4 cycle) time point by comparing the second signal intensity average with the third signal intensity average. In the same way, the control part 1100 can detect a change in the signal intensity average when the cycle of the AC current proceeds from a 2/8 cycle time point to a 3/8 cycle time point and from the 3/8 cycle time point to a 4/8 cycle (half cycle, i.e. ZCP) time point by comparing the third signal average with the fourth signal average and comparing the fourth signal average with the first signal average of the next cycle.

Furthermore, the control part 1100 can distinguish whether the detected average signal intensity change pattern matches a signal intensity change pattern pre-stored in the memory 1150, for example, a preset signal intensity change pattern of a high-frequency current signal generated when an AC arc occurs (hereinafter referred to as an arc signal intensity change pattern) (S1506).

For example, when an arc occurs, the intensity of the high-frequency current signal can be weakest in the no arc phase (around the ZCP) 1511, and then increase while entering the arc strike phase 1512. Furthermore, while passing through the arc strike phase 1512 to enter the arc conduct phase (maximum voltage state, 1/4 cycle) 1513, a current is conducted to reduce the intensity of the high-frequency current signal again. Furthermore, as the current conduction is discontinued while entering the arc quenches phase 1514 from the arc conduct phase 1513, the intensity of the high-frequency current signal can increase again, and the intensity of the high-frequency current signal can weaken again while entering the no arc phase 1521, which is a ZCP state.

Therefore, when an arc occurs, a change in the signal intensity average can increase when proceeding from the first signal average to the second signal average, decrease when proceeding from the second signal average to the third signal average, increase again when proceeding from the third signal average to the fourth signal average, and decrease again when proceeding from the fourth signal average to the first signal average of the next cycle. That is, a change pattern of the signal intensity average has a pattern of increase - decrease - increase - decrease, and can have a characteristic in which the intensity of the third signal intensity average is greater than that of the first signal intensity average.

Accordingly, the control part 1100 can determine that a pattern corresponding to an occurrence of an arc has been formed when a change pattern of the average signal intensity and a feature (a feature in which the intensity of the third signal intensity average is greater than that of the first signal intensity average) are detected in step S1506. Therefore, when the detected change pattern of the average signal intensity matches the arc signal intensity change pattern, the control part 1100 can proceed to step S1420 of FIG. 14 to drive the circuit breaking part 1110 to disconnect the load from the power line.

However, when the detected change pattern of the average signal intensity matches the arc signal intensity change pattern, the control part 1100 can proceed to the step S1404 of FIG. 14 to distinguish whether an initial waiting time period has elapsed since a time point at which a pulse signal having a specific polarity is applied and whether an insulation resistance corresponding to a polarity of a voltage signal currently applied to a power line has been calculated, and proceed to step S1401 of FIG. 14 again or step S1410 of FIG. 14 to detect an initial value depending on a result of the determination in the step S1404 of FIG. 14. In this case, when the process proceeds to the step S1401 of FIG. 14, the operation process of FIG. 15A can be performed again depending on whether a polarity signal reversal signal has elapsed.

Meanwhile, the control part 1100 can, of course, distinguish whether an arc has occurred based on whether a change pattern of the average signal intensity matching the arc occurrence pattern is detected by a preset number of times over a predetermined time period in order to more accurately distinguish whether an arc has occurred. In this case, the step S1506 can be distinguishing whether a change pattern of the average signal intensity corresponding to the arc signal intensity change pattern has been detected by the preset number of times over the predetermined time period.

Meanwhile, FIG. 16 is a more detailed description of an operation process of detecting whether an arc has occurred in a power line through the arc monitoring part 1120 in the step S1408 when a DC current flows in the power line during the operation process of the insulation monitoring device described in FIG. 14.

Referring to FIG. 16, the control part 1100 can decompose a high-frequency current signal acquired in the step S1406 of FIG. 14 into each frequency component (S1600). To this end, the control part 1100 can control the FFT 1125 to perform a fast Fourier transform on the acquired high-frequency current signal.

Furthermore, the control part 1100 can detect frequency components corresponding to at least one preset frequency band (arc frequency band) from among the frequency components of the decomposed high-frequency current signal (S1602). Here, the at least one preset frequency band can be a frequency band of a high-frequency current signal that is generated above a predetermined magnitude when an arc occurs in a power line through which a DC current flows. That is, the at least one arc frequency band, which is a frequency band related to an occurrence of an arc, can be acquired through previously investigated statistical data or a plurality of arc occurrence experiments conducted in relation to the present disclosure.

When frequency components included in the at least one arc frequency band are detected from among each frequency component of the high-frequency current signal decomposed in the step S1602, the control part 1100 can sum a magnitude (signal magnitude) of each of the detected frequency components (S1604). Furthermore, the summed signal magnitude can be compared with a preset reference magnitude (S1606).

When the signal magnitude summed in the step S1606 is above the preset reference magnitude, the control part 1100 can determine that an arc has occurred. Then, the control part 1100 can proceed to step S1420 of FIG. 14 to drive the circuit breaking part 1110 to disconnect the load from the power line.

However, when the signal magnitude summed in the step S1606 is below the preset reference magnitude, the control part 1100 can determine that an arc has not occurred. Then, the control part 1100 can proceed from the step S1606 to the step S1404 of FIG. 14 to distinguish whether an initial waiting time period has elapsed since a time point at which a pulse signal having a specific polarity is applied and whether an insulation resistance corresponding to a polarity of a voltage signal currently applied to a power line has been calculated, and proceed to step S1401 again or step S1410 of FIG. 14 to detect an initial value depending on a result of the determination in the step S1404 of FIG. 14. In this case, when the process proceeds to the step S1401 of FIG. 14, the operation process of FIG. 16 can be performed again depending on whether a polarity signal reversal signal has elapsed.

Meanwhile, since only one of an AC current or DC current normally flows through a power line, either the operation process of FIG. 15A or the operation process of FIG. 16 can be selectively performed depending on the current flowing through the power line. In this case, the control part 1100 can pre-set an operation mode of the arc monitoring part 1120 according to the current flowing in the power line, or the configuration of the arc monitoring part 1120 can be pre-configured to include components for detecting either an AC arc or a DC arc according to the current flowing in the power line.

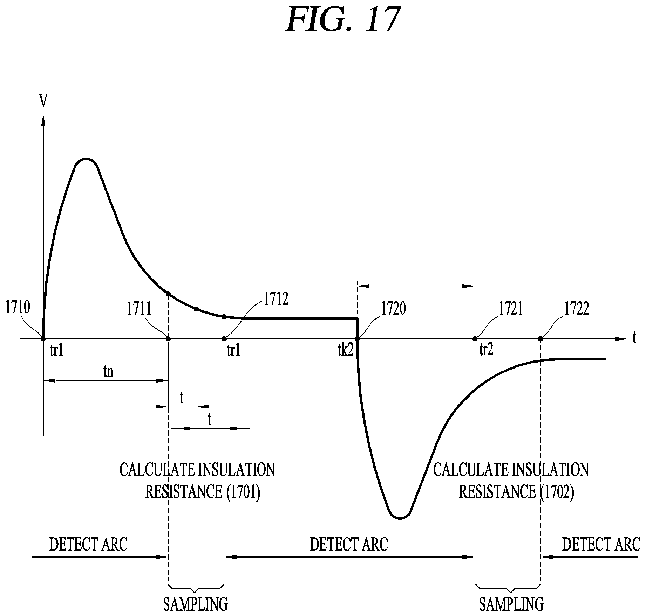

FIG. 17 is a conceptual diagram for explaining that arc monitoring and insulation monitoring are performed by the insulation monitoring device 1000 according to an embodiment of the present disclosure. Hereinafter, FIG. 17 will be described with reference to the flowchart of FIG. 14.

When a pulse signal is applied in step S1400 of FIG. 14, the control part 1100 can detect whether an arc has occurred based on a high-frequency current signal detected from a power line until a preset initial waiting time period has elapsed while the insulation resistance is not calculated in step S1404 of FIG. 14. In this case, the initial waiting time period is calculated from a time point at which the voltage polarity of the pulse signal is reversed, which can be shorter than a polarity reversal time period in which the voltage polarity of the pulse signal is reversed. Therefore, the expiration of the initial waiting time period can be first reached before the voltage polarity of the pulse signal is reversed again.

In addition, since the insulation resistance is not also calculated when the initial waiting time period is not reached, as shown in FIG. 17, the insulation monitoring device 1000 according to an embodiment of the present disclosure can continuously monitor an insulation state of a power line through whether the arc occurs during a time period from a time point 1710, 1720 at which polarity reversal is performed until the initial waiting time period elapses.

Meanwhile, when an initial waiting time period tn has elapsed (1711), the control part 1100 can start sampling according to a result of the determination in the step S1404 of FIG. 14 (whether the initial waiting time period has elapsed and whether the insulation resistance has not been calculated) to detect a voltage measured from a virtual circuit between the power line and the ground as an initial value t01. Furthermore, the control part 1100 can continue sampling from the initial value to calculate an average voltage of each sampling section, and determine the calculated average voltage as a steady-state voltage when a difference between the calculated average voltages is below a preset error value.

Furthermore, when the steady-state voltage is determined, the control part 1100 can calculate an insulation resistance based on the steady-state voltage determined before the polarity of the pulse signal is reversed, that is, when the polarity of the pulse signal is a different polarity, and the currently determined steady-state voltage tr2 (1701). Furthermore, when the insulation resistance is calculated, an insulation state of the power line can be distinguished based on the calculated insulation resistance. Therefore, after the initial waiting time period tn has elapsed, the insulation state of the power line can be monitored based on the calculated insulation resistance.

However, when the voltage polarity of the pulse signal is reversed, a voltage instability phenomenon as shown in FIG. 17 occurs due to charging and discharging by an insulation capacitance of the virtual circuit between the ground and the power line. In the case of this voltage instability phenomenon, it can vary depending on a magnitude of the insulation capacitance, but since the insulation capacitance of the virtual circuit is not known, it is difficult to accurately determine a time point at which the insulation resistance is calculated after the voltage polarity of the pulse signal is reversed. Accordingly, a conventional insulation monitoring device has a problem in that it is difficult to monitor an insulation state of a power line until the polarity of the pulse signal is reversed again after the insulation resistance is calculated to distinguish the insulation state.

However, in the case of the insulation monitoring device 1000 according to an embodiment of the present disclosure, as shown in FIG. 14, when the insulation resistance calculated as a result of the distinction in step S1420 is above a reference value, the process proceeds to step S1401 again to check whether a voltage polarity reversal time period of the pulse signal has elapsed, and when the polarity reversal time period has not elapsed, the process proceeds to step S1406 again to distinguish whether an arc has occurred according to the high-frequency current signal.

Meanwhile, since the distinction of whether an arc occurs in the high-frequency current signal is repeated until both conditions of step S1404 of FIG. 14 are satisfied to distinguish whether a preset initial waiting time period has elapsed while the insulation resistance is not calculated, as shown in FIG. 17, from a time point tr1 (1712) at which the insulation resistance is calculated, to a time point tr2 (1721) at which the initial waiting time period tn that is calculated again from a time point at which voltage polarity is reversed after a time point tk2 (1720) at which the voltage polarity of the pulse signal is reversed, has elapsed, that is, until a time point at which sampling is started for calculating the insulation resistance again, the distinction of whether an arc occurs in the high-frequency current signal can be made.

That is, the insulation monitoring device 1000 according to an embodiment of the present disclosure can perform insulation monitoring using the insulation resistance during a time period in which insulation resistance is calculated after an initial waiting time period has elapsed to allow insulation monitoring by the insulation resistance, and perform insulation monitoring according to whether an arc occurs based on a high-frequency current signal detected from a power line during the remaining time period. Accordingly, there is an effect of minimizing an idle period in which insulation monitoring of a power line is not performed.

Meanwhile, in the foregoing description of the present disclosure, specific embodiments have been described, but various modifications can be made without departing from the scope of the present disclosure. In particular, in an embodiment of the present disclosure, it has been described in which when an AC current flows in a power line, whether an arc (AC arc) has occurred is distinguished based on a pattern according to a change in the average signal intensity of samples acquired based on ZCP, and when a DC current flows, whether an arc (DC arc) has occurred is distinguished based on a frequency component of a high-frequency current signal included in a pre-stored arc frequency band, but the present disclosure is, of course, not limited thereto. That is, the AC arc or DC arc can, of course, also be distinguished through any other method.

The foregoing present disclosure can be implemented as computer-readable codes on a program-recorded medium. The computer-readable medium includes all kinds of recording devices in which data readable by a computer system is stored. Examples of the computer-readable medium include a hard disk drive (HDD), a solid state disk (SSD), a silicon disk drive (SDD), a ROM, a RAM, a CD-ROM, a magnetic tape, a floppy disk, an optical data storage device and the like, and also include a device implemented in the form of a carrier wave (e.g., transmission over the Internet). In addition, the computer can include the control part 100 of the circuit breaking part Therefore, the detailed description should not be limitedly construed in all of the aspects, and should be understood to be illustrative. The scope of the present disclosure should be determined by the reasonable interpretation of the appended claims, and all changes within the equivalent scope of the present disclosure are included in the scope of the present disclosure.

## Claims

1. An insulation monitoring system, the system comprising:
an arc monitoring part that detects a high-frequency current signal from a power line connecting between a power source and a load and monitors an occurrence of an arc due to insulation damage of the power line based on the detected high-frequency current signal;
an insulation monitoring part that calculates an insulation resistance between the power line and the ground and monitors an insulation state of the power line based on the calculated insulation resistance;
a circuit breaker that interrupts an electrical connection between the power line and the load depending on whether an interruption signal is received; and
a control part connected to the arc monitoring part and the insulation monitoring part to receive at least one of an insulation monitoring result related to the occurrence of the arc from the arc monitoring part and an insulation monitoring result related to the insulation resistance from the insulation monitoring part, and output the interruption signal to the circuit breaker based on the received insulation monitoring result.

2. The system of claim 1, wherein the insulation monitoring result received from the arc monitoring part comprises a signal intensity change pattern of a high-frequency current signal detected from the power line, and
wherein the control part distinguishes the insulation state of the power line based on whether the signal intensity change pattern matches a pre-stored arc pattern.

3. The system of claim 2, wherein the control part distinguishes, when the signal intensity change pattern matches the pre-stored arc pattern, whether a signal intensity change pattern detected from the high-frequency current signal for a predetermined time period matches the pre-stored arc pattern by a preset number of times, and distinguishes the insulation state of the power line based on a result of the distinction.

4. The system of claim 1, wherein the insulation monitoring result received from the arc monitoring part comprises magnitudes of frequency components included in at least one preset frequency band among frequency components of the high-frequency current signal detected from the power line, and
wherein the control part monitors the insulation state of the power line based on the magnitudes of the frequency components included in the insulation monitoring result.

5. The system of claim 4, wherein the arc monitoring part comprises:
a high frequency current transformer (HFCT) that detects the high-frequency current signal from the power line;
a fast Fourier transformer (FFT) that decomposes the high-frequency current signal into a magnitude for each frequency component;
a memory comprising information on at least one frequency band related to a high-frequency current signal generated when an arc occurs; and
an arc monitoring control part that detects at least one or more frequency components included in at least one frequency band stored in the memory from among each frequency component of the decomposed high-frequency current signal, and transmits the insulation monitoring result including the magnitudes of the detected frequency components to the control part.

6. The system of claim 1, wherein the insulation monitoring part transmits, when a polarity of a pulse signal applied to the power line is reversed, a notification signal notifying the polarity reversal to the control part, and transmits, when the insulation resistance corresponding to the pulse signal whose polarity is reversed is calculated, the calculated insulation resistance to the control part.

7. The system of claim 6, wherein the control part monitors, when the notification signal is received from the insulation monitoring part, an insulation state of the power line based on the insulation monitoring result received from the arc monitoring part until the insulation resistance calculated by the insulation monitoring part is received, and monitors, when the insulation resistance is received, the insulation state of the power line based on the insulation monitoring result received from the insulation monitoring part.

8. The system of claim 1, wherein the circuit breaker comprises at least one semiconductor switch comprising a source terminal connected to a power source side of the power line, a drain terminal connected to a load side of the power line, and a gate terminal electrically connecting between the source terminal and the drain terminal based on a gate voltage applied thereto, and a gate driver applying the gate voltage to the gate terminal, and
wherein the control part controls the gate driver to apply a gate voltage below a preset threshold voltage based on an insulation monitoring result received from at least one of the arc monitoring part and the insulation monitoring part.

9. A control method for an insulation monitoring system comprising an arc monitoring part that monitors an occurrence of an arc due to insulation damage of a power line, an insulation monitoring part that calculates an insulation resistance between the power line and the ground, and a circuit breaking part that disconnects a load from the power line, the method comprising:
transmitting, by the insulation monitoring part, when the polarity of the pulse signal applied to the power line is reversed to calculate the insulation resistance, a notification signal notifying the polarity reversal of the pulse signal to the circuit breaking part;
receiving, by the circuit breaking part, when the notification signal is received, a first insulation monitoring result related to the occurrence of the arc from the arc monitoring part;
distinguishing, by the circuit breaking part, an insulation state of the power line based on the first insulation monitoring result;
disconnecting, by the circuit breaking part, when insulation damage is detected as a result of the insulation state distinction based on the first insulation monitoring result, the load from the power line;
calculating, by the insulation monitoring part, while the circuit breaking part distinguishes the insulation state of the power line based on the first insulation monitoring result, an insulation resistance and transmitting the calculated insulation resistance to the circuit breaking part;
receiving, by the circuit breaking part, when insulation damage is not detected as a result of the insulation state distinction based on the first insulation monitoring result, the insulation resistance and re-distinguishing the insulation state of the power line based on the received insulation resistance; and
disconnecting, by the circuit breaking part, the load from the power line according to a result of the re-distinction.

10. The method of claim 9, wherein the distinguishing, by the circuit breaking part, of an insulation state of the power line based on the first insulation monitoring result comprises:
receiving, by the circuit breaking part, magnitudes of at least one or more preset frequency components from the arc monitoring part; and
distinguishing, by the circuit breaking part, the insulation state of the power line based on the received magnitudes of frequency components, and
wherein the magnitudes of frequency components received from the arc monitoring part are frequency components extracted by the arc monitoring part based on at least one frequency band related to an occurrence of an arc from among the frequency components of a high-frequency current signal detected from the power line.

11. An insulation monitoring device, the device comprising:
an arc monitoring part that detects a high-frequency current signal from a power line connecting between a power source and a load and collects an analysis result of analyzing the detected high-frequency current signal;
an insulation monitoring part that calculates an insulation resistance between the power line and the ground;
a circuit breaking part for interrupting a connection between the power source and the load; and
a control part that allows the insulation monitoring part to distinguish an insulation state of the power line using either an analysis result of the high-frequency current signal or the insulation resistance, depending on a polarity reversal time period after a voltage polarity of a pulse signal applied to the power line is reversed until the voltage polarity is reversed again, an initial waiting time period after the voltage polarity of the pulse signal is reversed until initial sampling is performed, and whether the insulation resistance is calculated in order to calculate the insulation resistance, and controls the circuit breaking part to disconnect a connection between the power source and the load according to a result of the distinction.

12. The device of claim 11, wherein the analysis result of analyzing the high-frequency current signal comprises a signal intensity change pattern of the high-frequency current signal detected from the power line, and
wherein the control part distinguishes the insulation state of the power line based on whether the signal intensity change pattern matches a pre-stored arc signal intensity change pattern.

13. The device of claim 12, wherein the signal intensity change pattern is a pattern according to an intensity change of a high-frequency current signal detected at each of a second time point between a first time point at which an AC current flowing in the power line reaches a zero crossing point (ZCP), and a third time point corresponding to a 1/4 cycle of the AC current, and a fourth time point between the third time point and a time point at which it reaches the ZCP again, and
wherein the arc signal intensity change pattern is a pattern corresponding to a phased signal intensity change of a high-frequency current signal that occurs when an arc occurs in the power line.

14. The device of claim 13, wherein the arc monitoring part acquires a preset number of intensity samples of the high-frequency current signal based on each of the first to fourth time points, averages the acquired samples for each time point to calculate an average signal intensity for each time point, and detects a pattern in which the calculated average signal intensity for each time point changes as the signal intensity change pattern.

15. The device of claim 11, wherein the analysis result of analyzing the high-frequency current signal comprises magnitudes of frequency components detected based on at least one preset frequency band among frequency components of the high-frequency current signal detected from the power line, and
wherein the control part monitors the insulation state of the power line based on the magnitudes of the detected frequency components.

16. The device of claim 11, wherein the control part controls, when the initial waiting time period has elapsed, the insulation monitoring part to calculate an insulation resistance, and distinguishes an insulation state of the power line based on the calculated insulation resistance, and distinguishes, when the insulation resistance has been calculated, the insulation state of the power line based on the analysis result of analyzing the high-frequency current signal received from the arc monitoring part after the voltage polarity of the pulse signal is reversed again until the initial waiting time period has elapsed again for the pulse signal whose voltage polarity has been reversed.

17. A method of controlling the device of claim 11, the method comprising:
checking whether a first condition that is satisfied depending on whether a time period required from a time point at which a predetermined magnitude of a pulse signal having a positive or negative voltage is applied to a power line has elapsed a preset initial waiting time period and a second condition that is satisfied depending on whether an insulation resistance has been calculated are both satisfied;
distinguishing, when neither of the first and second conditions is satisfied, whether an arc has occurred in the power line based on a high-frequency current signal detected from the power line until both the first and second conditions are satisfied;
calculating, as a result of distinguishing whether an arc has occurred, when both the first and second conditions are satisfied while an arc has not occurred, an insulation resistance between the power line and the ground;
distinguishing, when the insulation resistance is calculated, an insulation state of the power line based on the calculated magnitude of the insulation resistance; and
repeatedly performing checking whether both the first and second conditions are satisfied based on a result of the insulation state distinction and distinguishing the insulation state of the power line based on the magnitude of the insulation resistance.

18. The method of claim 17, wherein the checking of whether both the first and second conditions are satisfied further comprises:
checking whether a polarity reversal time period of a preset pulse signal has elapsed; and
reversing, when the polarity reversal time period has elapsed, a voltage polarity of the pulse signal, and
wherein when the polarity reversal time period has elapsed, the required time period is initialized.
